# EUROPEAN PATENT APPLICATION

(11) **EP 4 664 217 A2**
(43) Date of publication of application: **17.12.2025**
(21) Application number: 24218511.4
(22) Date of filing: 09.12.2024
(51) Int. Cl.: G05B 19/418, H01L 21/67, H01L 21/673, H01L 21/677, H01L 21/68

(54) **SUBSTRATE PROCESSING SYSTEM**

(30) Priority: 15.12.2023 JP 2023212287; 24.09.2024 JP 2024165396
(71) Applicant: SCREEN Holdings Co., Ltd., Kyoto-shi, Kyoto 602-8585 (JP)
(72) Inventor: KIMURA, Ryuichi, Kyoto, 602-8585 (JP); MATSUI, Hiroakira, Kyoto, 602-8585 (JP); KUBO, Yasushi, Kyoto, 602-8585 (JP)
(74) Representative: Kilian Kilian & Partner mbB

(57) **Abstract**

A substrate processing system includes a first processing apparatus, a second processing apparatus, and an integrated control device. The first processing apparatus executes first processing on substrates in accordance with a job. The second processing apparatus executes second processing on substrates in accordance with a job. The integrated control device generates a first virtual job and a second virtual job in accordance with a command to create an integrated job, received from an external control device. The first processing apparatus executes at least part of the first processing on substrates in accordance with the first virtual job. The second processing apparatus executes, in accordance with the second virtual job, at least part of the second processing on the substrates that have been processed by the first processing apparatus.

## Description

### CROSS-REFERENCE TO RELATED APPLICATIONS

The present application claims priority benefit of Japanese Patent Applications No. JP2023-212287 filed in the Japan Patent Office on December 15, 2023 and No. JP2024-165396 filed in the Japan Patent Office on September 24, 2024, the entire disclosures of which are incorporated herein by reference.

### TECHNICAL FIELD

The present invention relates to a substrate processing system.

### BACKGROUND ART

Substrate processing apparatuses have been proposed that execute batch processing and sheet-fed processing on substrates by one apparatus (e.g., see Japanese Patent Application Laid-Open No. 2021-64654: Document 1). Document 1 discloses a configuration in which a transporter, a sheet-fed processing part, a batch processing part, and an interface are provided within one apparatus. In the substrate processing apparatus disclosed in Document 1, the transporter transports a cassette that contains a plurality of substrates into and out of the apparatus. The batch processing part executes a lot that contains a plurality of substrates by one operation. The sheet-fed processing part processes a lot of substrates one by one. The interface transfers substrates between the batch processing part and the sheet-fed processing part. Specifically, the batch processing part executes chemical solution processing and rinse processing, the chemical solution processing being processing a plurality of substrates, which configure a lot, by one operation by using a chemical solution such as a dilute hydrofluoric acid, a phosphate solution, and SC1 (a mixed solution that contains ammonia, a hydrogen peroxide solution, and water), the rinse processing being rinsing a plurality of substrates, which configure a lot, by one operation by using a rinsing liquid. The sheet-fed processing part supplies a dry liquid (e.g., isopropyl alcohol) to substrates that have undergone the rinse processing performed by the batch processing part, one by one to form a liquid membrane of the dry liquid on each substrate and then dries the substrates one by one by using a supercritical fluid.

In the substrate processing apparatus disclosed in Document 1, however, the sheet-fed processing part executes only the processing for drying substrates by using a supercritical fluid (dry processing) after the liquid membrane of the dry liquid is formed on the substrates. Thus, the sheet-fed processing part is incapable of executing processing using a chemical solution such as a dilute hydrofluoric acid, a phosphate solution, and SC1 (chemical solution processing).

In contrast, it is conceivable to construct a substrate processing system using a batch processing apparatus and a sheet-fed processing apparatus, in which the execution of a series of substrate processing by only the batch processing apparatus and the execution of a series of substrate processing by only the sheet-fed processing apparatus are selectable in addition to a series of substrate processing that combines chemical solution processing and rinse processing executed by the batch processing apparatus and dry processing executed by the sheet-fed processing apparatus.

However, in the case where a series of substrate processing (e.g., substrate processing that continuously executes chemical solution processing, rinse processing, and dry processing) is executed by a plurality of processing apparatuses, a host computer needs to issue a command to create a job (control job) to each of the processing apparatuses so as to allow the processing apparatuses to execute the series of substrate processing. Accordingly, a new system (software) needs to be introduced into an existing host computer, and this increases the load on an operator who manages the host computer. If a plurality of processing apparatus can be controlled in accordance with one command to create a job (control job), the load on the operator who manages the host computer will be reduced, but the use of only one job (control job) to cause a plurality of processing apparatuses to execute substrate processing is not compliant with SEMI standards.

### SUMMARY OF THE INVENTION

The present invention is intended for a substrate processing system, and it is an object of the present invention to provide a substrate processing system capable of suppressing an increase in the load on an operator who manages an external control device.

According to a first aspect of the present invention, a substrate processing system includes a first processing apparatus, a second processing apparatus, and an integrated control device. The first processing apparatus executes first processing on a substrate in accordance with a job. The second processing apparatus executes second processing on a substrate in accordance with a job. The integrated control device controls the first processing apparatus and the second processing apparatus in accordance with a command received from an external control device. The job is a command to execute processing from transporting a substrate from a substrate storage container into a processing apparatus and executing processing on the substrate inside the processing apparatus to transporting out the substrate from the inside of the processing apparatus to the substrate storage container or to another substrate storage container different from the substrate storage container. The integrated control device generates a first virtual job and a second virtual job in accordance with a command to create an integrated job, the command being received from the external control device. The first processing apparatus executes at least part of the first processing on a substrate in accordance with the first virtual job. The second processing apparatus executes at least part of the second processing on the substrate processed by the first processing apparatus, in accordance with the second virtual job.

This substrate processing system is capable of suppressing an increase in the load on an operator who manages the external control device.

In one embodiment, the substrate processing system described above further includes a first coupler. The first coupler couples the first processing apparatus and the second processing apparatus. The first coupler includes a substrate transport mechanism. The substrate transport mechanism transports the substrate processed by the first processing apparatus to the second processing apparatus.

In one embodiment, the substrate processing system described above further includes a substrate standby part. In the substrate standby part, the substrate having undergone at least part of the first processing is on standby. The substrate transport mechanism transports the substrate that is on standby in the substrate standby part to the second processing apparatus. The integrated control device generates the second virtual job in response to the substrate becoming on standby in the substrate standby part.

In one embodiment, the second processing apparatus includes a storage. The storage stores information for identifying a virtual container placement part. The integrated control device generates, in response to the substrate becoming on standby in the substrate standby part, information indicating that a virtual substrate storage container is placed on the virtual container placement part.

In one embodiment, the first processing apparatus includes a first casing having a first opening. The second processing apparatus includes a second casing having a second opening. The first coupler further includes a first coupler casing. The first coupler casing has one end connected to the first casing. The first coupler casing has the other end connected to the second casing. The substrate transport mechanism transports out the substrate processed by the first processing apparatus through the first opening of the first casing, transports the substrate through an interior of the first coupler casing, and transports the substrate from the second opening into the second casing.

In one embodiment, the substrate processing system described above further includes a second coupler. The second coupler couples the first processing apparatus and the second processing apparatus. The first processing apparatus includes a first casing and a first container placement part on which a substrate storage container is placed. The second processing apparatus includes a second casing and a second container placement part on which the substrate storage container is placed. The first container placement part is provided outside the first casing. The second container placement part is provided outside the second casing. The second coupler includes a container transport mechanism that transports the substrate storage container placed on the first container placement part to the second container placement part.

In one embodiment, the second coupler further includes a second coupler casing. The second coupler casing covers the first container placement part and the second container placement part. The container transport mechanism transports the substrate storage container inside the second coupler casing.

In one embodiment, the first processing apparatus includes a first storage. The first storage stores a first recipe that prescribes the first processing. The second processing apparatus includes a second storage that stores a second recipe that prescribes the second processing. The integrated control device edits an integrated recipe that integrates the first recipe and the second recipe with each other, and stores integrated recipe information. When a command to create the integrated job is received from the external control device, the integrated control device generates the first virtual job and the second virtual job with reference to the integrated recipe information. The first virtual job includes information for identifying the first recipe integrated into the integrated recipe. The second virtual job includes information for identifying the second recipe integrated into the integrated recipe.

In one embodiment, the first processing apparatus executes part of the first processing. When editing the integrated recipe, the integrated control device edits the first recipe so that part of the first processing is executed in accordance with the command received from the external control device.

In one embodiment, the second processing apparatus executes part of the second processing. When editing the integrated recipe, the integrated control device edits the second recipe so that part of the second processing is executed in accordance with the command received from the external control device.

In one embodiment, the first storage stores a plurality of first recipes that are different from each other and each are the first recipe. When editing the integrated recipe, the integrated control device integrates the first recipe into the integrated recipe in a unit of one substrate. When two or more of the plurality of first recipes are integrated into the integrated recipe, the integrated control device generates two or more first virtual jobs each being the first virtual job.

In one embodiment, the second storage stores a plurality of second recopies that are different from each other and each are the second recipe. When editing the integrated recipe, the integrated control device integrates the second recipe into the integrated recipe in a unit of one substrate. When two or more of the plurality of second recipes are integrated into the integrated recipe, the integrated control device generates two or more second virtual jobs each being the second virtual job.

In one embodiment, the first processing apparatus notifies the integrated control device of an event that has occurred in the first processing apparatus, together with information for identifying the first virtual job. The second processing apparatus notifies the integrated control device of an event that has occurred in the second processing apparatus, together with information for identifying the second virtual job. The integrated control device notifies the external control device of the event that has occurred in the first processing apparatus, together with information for identifying the integrated job. The integrated control device notifies the external control device of the event that has occurred in the second processing apparatus, together with information for identifying the integrated job,

In one embodiment, the event that has occurred in the first processing apparatus includes a completed event that indicates completion of processing based on the first virtual job. When an event notified from the first processing apparatus is a completed event indicating completion of the first virtual job, the integrated control device determines not to notify the external control device of the completed event.

In one embodiment, the integrated control device generates the second virtual job a plurality of times. The event that has occurred in the second processing apparatus includes a plurality of completed events that respectively indicate completion of processing based on a plurality of second virtual jobs each being the second virtual job. The plurality of completed events include a last completed event that is a completed event notified at last from the second processing apparatus. When the completed event notified from the second processing apparatus is not the last completed event, the integrated control device determines not to notify the external control device of the completed event. When the completed event notified from the second processing apparatus is the last completed event, the integrated control device notifies the external control device of the completed event, together with information for identifying the integrated job.

In one embodiment, the first processing apparatus includes a first control device that controls execution of the first processing. The second processing apparatus includes a second control device that controls execution of the second processing. One of the first control device and the second control device serves also as the integrated control device.

In one embodiment, the first processing apparatus includes a batch-type substrate processing apparatus capable of processing a plurality of substrates by one operation. The second processing apparatus includes a sheet fed-type substrate processing apparatus that processes a plurality of substrates one by one.

In one embodiment, the integrated control device generates the first virtual job to control the batch-type substrate processing apparatus. The batch-type substrate processing apparatus executes part of the first processing on the plurality of substrates in accordance with the first virtual job. After the batch-type substrate processing apparatus has completed the processing on the plurality of substrates, the integrated control device generates the second virtual job to control the sheet fed-type substrate processing apparatus. The sheet fed-type substrate processing apparatus executes part of the second processing on each of some of the plurality of substrates in a unit of one substrate in accordance with the second virtual job. After the sheet fed-type substrate processing apparatus has completed the processing on the some of the plurality of substrates, the integrated control device again generates the second virtual job to control the sheet fed-type substrate processing apparatus. The sheet fed-type substrate processing apparatus executes part of the second processing on each of remaining ones of the plurality of substrates in a unit of one substrate in accordance with the second virtual job.

According to another aspect of the present invention, a substrate processing system includes a first processing apparatus, a plurality of second processing apparatuses, an integrated control device, and a container transport mechanism. The first processing apparatus executes first processing on a substrate in accordance with a job. The plurality of second processing apparatuses each execute second processing on a substrate in accordance with a job. The integrated control device controls the first processing apparatus and the plurality of second processing apparatuses in accordance with a command received from an external control device. The local transport mechanism is movable independently of the first processing apparatus and the plurality of second processing apparatuses. The job is a command to execute processing from transporting a substrate from a substrate storage container into a processing apparatus and executing processing on the substrate inside the processing apparatus to transporting out the substrate from an interior of the processing device to the substrate storage container or to another substrate storage container different from the substrate storage container. The integrated control device generates a first virtual job and a second virtual job in accordance with a command to create an integrated job, the command being received from the external control device. The first processing apparatus executes at least part of the first processing on a substrate in accordance with the first virtual job. One second processing apparatus selected from among the plurality of second processing apparatuses by the integrated control device executes, in accordance with the second virtual job, at least part of the second processing on the substrate processed by the first processing apparatus. The first processing apparatus includes a first container placement part on which a substrate storage container is placed. Each of the plurality of second processing apparatuses includes a second container placement part on which the substrate storage container is placed. The local transport mechanism transports the substrate storage container that contains the substrate processed by the first processing apparatus, from the first container placement part to the second container placement part of the one second processing apparatus selected from among the plurality of processing apparatuses. This substrate processing system is capable of suppressing an increase in the load on an operator who manages the external control device.

In one embodiment, the integrated control device stores processing standby information and maintenance information, the processing standby information indicating a total number of substrates that are on standby in each of the plurality of second processing apparatuses, the maintenance information being information about each of the plurality of second processing apparatuses. The integrated control device selects the one second processing apparatus from among the plurality of second processing apparatuses in accordance with the processing standby information and the maintenance information that are about each of the plurality of second processing apparatuses.

In one embodiment, the plurality of second processing apparatuses include a second processing apparatus group of a first type and a second processing apparatus group of a second type different from the first type. The second processing apparatus group of the second type is arranged in a region that is spaced from a region in which the second processing apparatus group (500) of the first type is arranged. The integrated control device selects one second processing apparatus group out of the second processing apparatus group of the first type and the second processing apparatus group of the second type in accordance with a command to create the integrated job, and selects the one second processing apparatus from among the one second processing apparatus group.

In one embodiment, the first processing apparatus includes a batch-type substrate processing apparatus capable of processing a plurality of substrates by one operation. Each of the plurality of second processing apparatuses includes a sheet fed-type substrate processing apparatus that processes a plurality of substrates one by one.

These and other objects, features, aspects and advantages of the present invention will become more apparent from the following detailed description of the present invention when taken in conjunction with the accompanying drawings.

### BRIEF DESCRIPTION OF DRAWINGS

Fig. 1 is a block diagram showing a configuration of a substrate processing system according to Embodiment 1 of the present invention.
Fig. 2 is a flowchart showing a procedure of processing executed by a controller of an integrated control device included in the substrate processing system according to Embodiment 1 of the present invention.
Fig. 3 is a plan view schematically showing the configuration of the substrate processing system according to Embodiment 1 of the present invention.
Fig. 4 is a side sectional view schematically showing the interior of a sheet-fed processing unit.
Fig. 5 is a diagram showing one example of a first recipe editing screen.
Fig. 6 is a flowchart showing a procedure of integrated-recipe editing processing executed by the controller of the integrated control device included in the substrate processing system according to Embodiment 1 of the present invention.
Fig. 7 is a flowchart showing a procedure of processing executed by the controller of the integrated control device included in the substrate processing system according to Embodiment 1 of the present invention.
Fig. 8 is a flowchart showing a procedure of processing executed by a first control device of a batch processing apparatus included in the substrate processing system according to Embodiment 1 of the present invention.
Fig. 9 is a flowchart showing a procedure of processing executed by the first control device of the batch processing apparatus in accordance with a first virtual job.
Fig. 10 is a flowchart showing a procedure of processing executed by the controller of the integrated control device included in the substrate processing system according to Embodiment 1 of the present invention.
Fig. 11 is a flowchart showing a procedure of processing executed by the controller of the integrated control device included in the substrate processing system according to Embodiment 1 of the present invention.
Fig. 12 is a flowchart showing a procedure of processing executed by a second control device of the sheet-fed processing apparatus in accordance with a second virtual job.
Fig. 13 is a flowchart showing a procedure of notification processing executed by a first controller of a first processing apparatus when an event has occurred in the first processing apparatus that operates in accordance with the first virtual job.
Fig. 14 is a flowchart showing a procedure of notification processing executed by the controller of the integrated control device when an event has occurred in the first processing apparatus that operates in accordance with the first virtual job.
Fig. 15 is a flowchart showing a procedure of notification processing executed by a second controller of a second processing apparatus when a completed event has occurred in the second processing apparatus that operates in accordance with the second virtual job.
Fig. 16 is a flowchart showing a procedure of notification processing executed by the controller of the integrated control device when a completed event has occurred in the second processing apparatus that operates in accordance with the second virtual job.
Fig. 17 is a diagram showing one example of a second recipe editing screen.
Fig. 18 is a flowchart showing a procedure of processing executed by the controller of the integrated control device included in a variation of the substrate processing system according to Embodiment 1 of the present invention.
Fig. 19 is a block diagram showing a configuration of a substrate processing system according to Embodiment 2 of the present invention.
Fig. 20 is a block diagram showing a configuration of a substrate processing system according to Embodiment 3 of the present invention.
Fig. 21 is a block diagram showing a configuration of a substrate processing system according to Embodiment 4 of the present invention.

### DESCRIPTION OF EMBODIMENTS

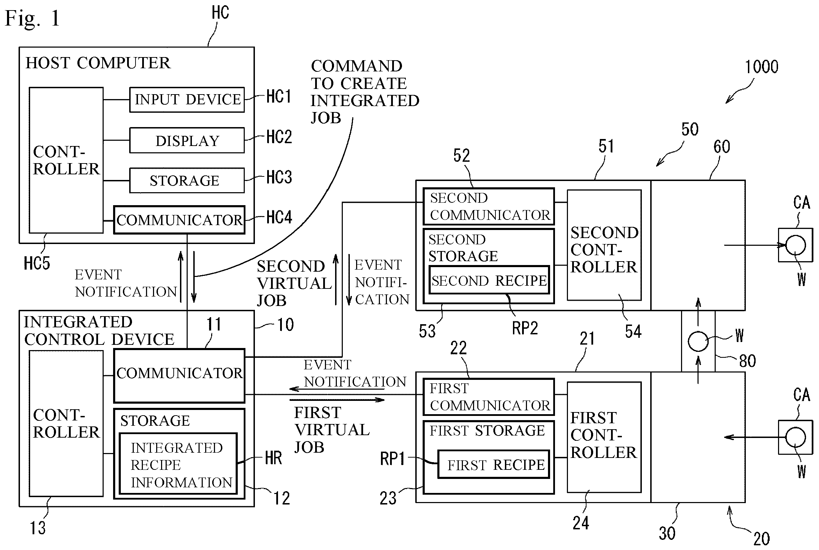

Embodiments of a substrate processing system according to the present invention are described hereinafter with reference to the drawings (Figs. 1 to 21). It is, however, noted that the present invention is not intended to be limited to the embodiments described below and can be implemented in various modes without departing from the scope of the present invention. Note that redundant descriptions may be omitted as appropriate. In the drawings, identical or corresponding parts are given the same reference signs, and descriptions thereof shall not be repeated.

"Substrates" according to the embodiments of the present invention may be any of various substrates such as semiconductor wafers, photomask glass substrates, glass substrates for liquid crystal display, glass substrates for plasma display, substrates for field emission display (FED), optical disk substrates, magnetic disk substrates, or magneto-optical disk substrates. In the following description, mainly a substrate processing system used in the processing of disc-shaped semiconductor wafers is used as an example, but the present invention is also similarly applicable to processing of the various substrates exemplified above. The present invention is also applicable to various shapes of substrates.

### Embodiment 1

Fig. 1 is a block diagram showing a configuration of a substrate processing system 1000 according to an embodiment of the present invention. The substrate processing system 1000 according to the present embodiment processes substrates W. Specifically, the substrate processing system 1000 according to the present embodiment executes substrate processing on substrates W. For example, the substrate processing may involve chemical solution processing, rinse processing, and dry processing. In the chemical solution processing, substrates W are processed using a chemical solution. The chemical solution processing may, for example, be etch processing or cleaning processing. The rinse processing refers to processing for washing away a chemical solution from substrates W. The dry processing refers to processing for drying substrates W.

As shown in Fig. 1, the substrate processing system 1000 according to the present embodiment includes an integrated control device 10, a first processing apparatus 20, and a second processing apparatus 50. The substrate processing system 1000 is controlled by a host computer HC. The host computer HC is one example of an "external control device."

The first processing apparatus 20 executes first processing on substrates W in accordance with one job. The job as used herein refers to a command given to a processing apparatus. Specifically, the job refers to a control job. That is, the job is a command to execute processing from transporting a substrate W from a substrate storage container CA into a processing apparatus and executing processing on the substrate W inside the processing apparatus to transporting out the substrate W from the inside of the processing apparatus to the same substrate storage container CA or to a different substrate storage container CA.

To be more specific, the first processing apparatus 20 is configured to, in accordance with one job, transport substrates W from a substrate storage container CA into the first processing apparatus 20, executing processing (first processing) on the substrates W inside the first processing apparatus 20, and then transporting out the substrates W from the inside of the first processing apparatus 20 to the same substrate storage container CA or to a different substrate storage container CA. The first processing apparatus 20 may be an existing processing apparatus, an apparatus produced by modifying an existing processing apparatus, or a new processing apparatus.

In the present embodiment, the first processing apparatus 20 is a batch processing apparatus. For example, the first processing apparatus 20 may be batch-type cleaning equipment or batch-type etching equipment. The cleaning equipment and the etching equipment are substrate processing apparatuses. The batch processing apparatus executes batch processing for processing a plurality of substrates W by one operation. Specifically, the batch processing apparatus processes substrates W, which configure a lot, by one operation. A lot is configured of one or more substrates W. The number of substrates W included in a lot may, for example, be greater than or equal to one and less than or equal to 25. One substrate storage container CA contains one lot of substrates W. The batch processing apparatus is configured to transport out a lot of substrates W from a substrate storage container CA and execute, for example, the chemical solution processing, the rinse processing, and the dry processing on the lot of substrates W.

Hereinafter, the first processing apparatus 20 may also be referred to as the "batch processing apparatus 20." In the present embodiment, the batch processing apparatus 20 processes two lots by one operation. To be more specific, the batch processing apparatus 20 combines two lots into one lot. Hereinafter, such one lot that is obtained by combining two lots may also be referred to as a "set of lots."

Note that a substrate storage container CA contains a plurality of substrates W in stacked layers. Specifically, a plurality of substrates W oriented in a horizontal position are stacked one above another and spaced from one another in a vertical direction within a substrate storage container CA. The language being oriented in a horizontal position as used herein refers to a state in which the direction of the thickness of substrates W is in the vertical direction. The substrate storage container CA may, for example, be a front opening unified pod (FOUP), a standard mechanical inter face (SMIF) pod, or an open cassette (OC).

The second processing apparatus 50 executes second processing on substrates W in accordance with one job. To be more specific, the second processing apparatus 50 is configured to, in accordance with one job, transport substrates W from a substrate storage container CA into the second processing apparatus 50, executes processing (second processing) on the substrates W inside the second processing apparatus 50, and then transport the substrates W from the inside of the second processing apparatus 50 to the same substrate storage container CA or a different substrate storage container CA. Like the first processing apparatus 20, the second processing apparatus 50 may be an existing processing apparatus, an apparatus produced by modifying an existing processing apparatus, or a new processing apparatus.

In the present embodiment, the second processing apparatus 50 is a sheet-fed processing apparatus. For example, the second processing apparatus 50 may be sheet-fed-type cleaning equipment or sheet-fed-type etching equipment. The sheet-fed processing apparatus executes sheet-fed processing for processing substrates W one by one. Specifically, the sheet-fed processing apparatus transports out substrates W from a substrate storage container CA one by one and processes the substrates W one by one. For example, the sheet-fed processing apparatus may be configured to be capable of executing chemical solution processing, rinse processing, and dry processing on one substrate W. Hereinafter, the second processing apparatus 50 may also be referred to as the "sheet-fed processing apparatus 50."

The integrated control device 10 controls the first processing apparatus 20 and the second processing apparatus 50 in accordance with a command received from the host computer HC. More specifically, the integrated control device 10 generates a first virtual job and a second virtual job in accordance with a command to create an integrated job, received from the host computer HC. Then, the integrated control device 10 causes the first processing apparatus 20 to execute the first virtual job and causes the second processing apparatus 50 to execute the second virtual job. For example, the integrated control device 10 may be a general-purpose computer system or a dedicated computer system. The command to create an integrated job as used herein refers to a command to create a control job. The first virtual job is a control job. Similarly, the second virtual job is a control job.

The first processing apparatus 20 executes at least part of the first processing on substrates W in accordance with the first virtual job. The second processing apparatus 50 executes at least part of the second processing on the substrates W processed by the first processing apparatus 20, in accordance with the second virtual job.

In the present embodiment, the first virtual job causes the batch processing apparatus 20 to execute the chemical solution processing and the rinse processing. The second virtual job causes the sheet-fed processing apparatus 50 to execute the dry processing. Thus, the batch processing apparatus 20 executes, in accordance with the first virtual job, the chemical solution processing and the rinse processing among the chemical solution processing, the rinse processing, and the dry processing on a set of lots. The sheet-fed processing apparatus 50 executes, in accordance with the second virtual job, the dry processing among the chemical solution processing, the rinse processing, and the dry processing on each substrate W of the lot that has undergone the batch processing.

According to Embodiment 1, the host computer HC may command the integrated control device 10 to create one job as described above. Thus, the host computer HC does not necessarily have to command each of the first processing apparatus 20 and the second processing apparatus 50 to create a job. This eliminates the need to introduce a new system (software) into an existing host computer and suppresses an increase in the load on an operator who manages the host computer HC. According to Embodiment 1, as a result of the integrated control device 10 generating the first and second virtual jobs in accordance with a command received from the host computer HC, the first processing apparatus 20 and the second processing apparatus 50 execute a series of substrate processing (substrate processing for continuously performing the chemical solution processing, the rinse processing, and the dry processing) in cooperation with each other. This is compliant with SEMI standards because the first processing apparatus 20 and the second processing apparatus 50 do not execute substrate processing in accordance with one job.

Next, the substrate processing system 1000 according to the present embodiment is further described in detail with reference to Fig. 1. As shown in Fig. 1, the substrate processing system 1000 according to the present embodiment further includes a first coupler 80. The first coupler 80 couplers the first processing apparatus 20 and the second processing apparatus 50.

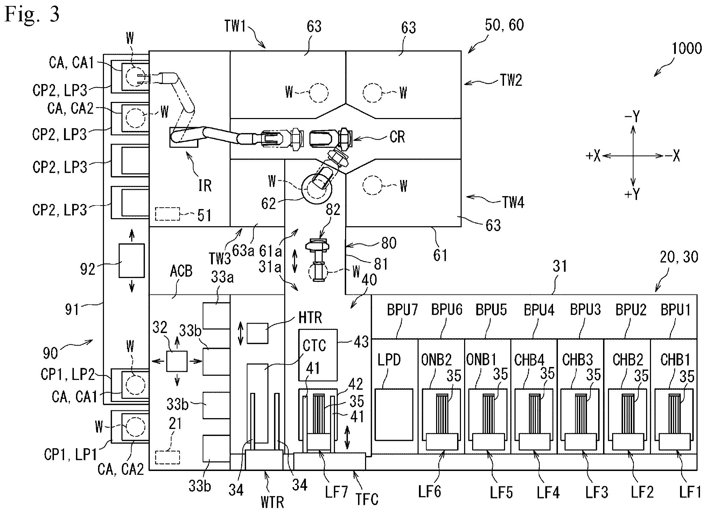

As will be described later with reference to Fig. 3, the first coupler 80 includes a substrate transport mechanism 82 that transports substrates W processed by the first processing apparatus 20 to the second processing apparatus 50. In the present embodiment, the substrate transport mechanism 82 of the first coupler 80 transports substrates W that have undergone the chemical solution processing and the rinse processing executed by the batch processing apparatus 20, one by one to the sheet-fed processing apparatus 50.

Next, configurations of the host computer HC, the integrated control device 10, the first processing apparatus 20, and the second processing apparatus 50 are described with reference to Fig. 1.

As show in Fig. 1, the host computer HC commands the integrated control device 10 to create an integrated job. For example, the host computer HC may be a general-purpose computer system or a dedicated computer system. The host computer HC may also be, for example, a manufacturing execution system (MES). Specifically, the host computer HC includes an input device HC1, a display HC2, a storage HC3, a communicator HC4, and a controller HC5.

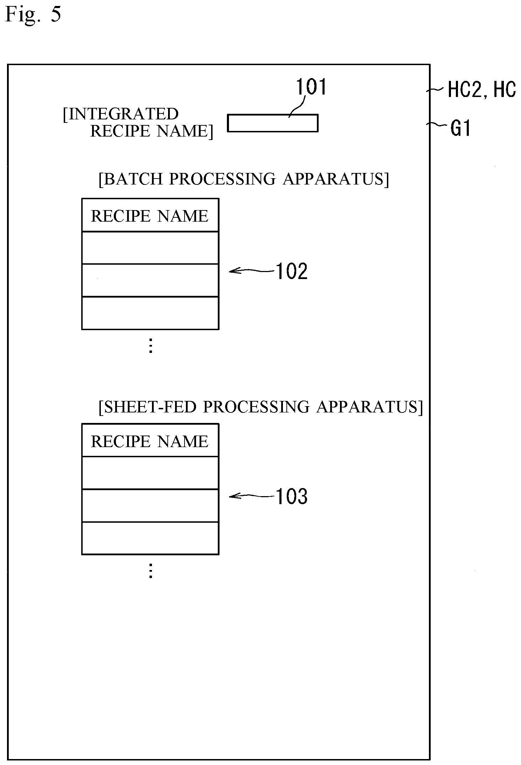

The input device HC1 includes a user interface device operated by an operator. The input device HC1 inputs a signal responsive to an operator's operation to the controller HC5. The input device HC1 may include, for example, a keyboard and a mouse. The input device HC1 may include a touch sensor that is superimposed on the display surface of the display HC2. A graphical interface may be configured by superimposing a touch sensor on the display surface of the display HC2. As will be described with reference to Fig. 5, for example, the operator may be able to edit a recipe by operating the input device HC1.

The display HC2 is controlled by the controller HC5 to display various screens. For example, the display HC2 may be controlled by the controller HC5 to display a first recipe editing screen G1, which will be described later with reference to Fig. 5. The display HC2 may include, for example, a display device such as a liquid crystal display or an organic electroluminescence (EL) display.

The storage HC3 includes main memory. The main memory may include, for example, semiconductor memory. The storage HC3 may further include auxiliary memory. The auxiliary memory may include, for example, at least either of semiconductor memory and a hard disk drive. The storage HC3 may be a removable medium. The storage HC3 stores various computer programs and a variety of data.

The communicator HC4 is connected to a network and communicates with the integrated control device 10. For example, the network may include a local area network (LAN) installed in a factory where the first processing apparatus 20 and the second processing apparatus 50 are provided. The communicator HC4 includes communication equipment. The communication equipment may, for example, be a network interface controller.

In the case where an existing host computer is used as the host computer HC, an existing communication interface may be used as a communication interface between the host computer HC and the integrated control device 10.

The communicator HC4 is controlled by the controller HC5 to transmit a signal that commands the integrated control device 10 to create a command. The communicator HC4 also receives a notification indicating the occurrence of an event from the integrated control device 10. The notification includes a notification indicating the occurrence of an event in the substrate processing system 1000. For example, when an event has occurred in which a substrate storage container CA has docked with the substrate processing system 1000, the communicator HC4 receives a notification indicating the docking of the substrate storage container CA with the substrate processing system 1000 from the integrated control device 10.

The controller HC5 includes a processor. For example, the controller HC5 may include a central processing unit (CPU) as the processor. The controller HC5 may include a graphics processing unit (GPU) as the processor. Alternatively, the controller HC5 may include a general-purpose arithmetic unit or a dedicated arithmetic unit. For example, the controller HC5 may include a field-programmable gate array (FPGA) or an application specific integrated circuit (ASIC) as the general-purpose arithmetic unit or the dedicated arithmetic unit.

The controller HC5 controls the display HC2, the storage HC3, and the communicator HC4 by executing computer programs stored in the storage HC3. When executing the computer programs, the controller HC5 may reference data stored in the storage HC3. For example, in the case where the notification received from the integrated control device 10 indicates the occurrence of an event in which a substrate storage container CA has docked with the substrate processing system 1000, the controller HC5 causes the communicator HC4 to transmit a command to create an integrated job.

Next, the integrated control device 10 is described. As shown in Fig. 1, the integrated control device 10 includes a communicator 11, a storage 12, and a controller 13.

The communicator 11 is connected to a network and communicates with the communicator HC4 of the host computer HC. The communicator 11 includes communication equipment. The communicator 11 is controlled by the controller 13 to notify the host computer HC of the occurrence of an event. The communicator 11 also receives a command to create an integrated job from the host computer HC.

The communicator 11 further communicates with the first processing apparatus 20 and the second processing apparatus 50. The communicator 11 is controlled by the controller 13 to transmit a first virtual job to the first processing apparatus 20 and transmit a second virtual job to the second processing apparatus 50. The communicator 11 is also notified of an event that has occurred in the first processing apparatus 20 and an event that has occurred in the second processing apparatus 50.

For example, when an event has occurred in which a substrate storage container CA is docked with the first processing apparatus 20, the first processing apparatus 20 notifies the integrated control device 10 of the occurrence of the event. When processing based on the first virtual job is completed, the first processing apparatus 20 also notifies the integrated control device 10 of the occurrence of the event. Similarly, when an event has occurred in which a substrate storage container CA has docked with the second processing apparatus 50, the second processing apparatus 50 notifies the integrated control device 10 of the occurrence of the event. When processing based on the second virtual job is completed, the second processing apparatus 50 also notifies the integrated control device 10 of the occurrence of the event.

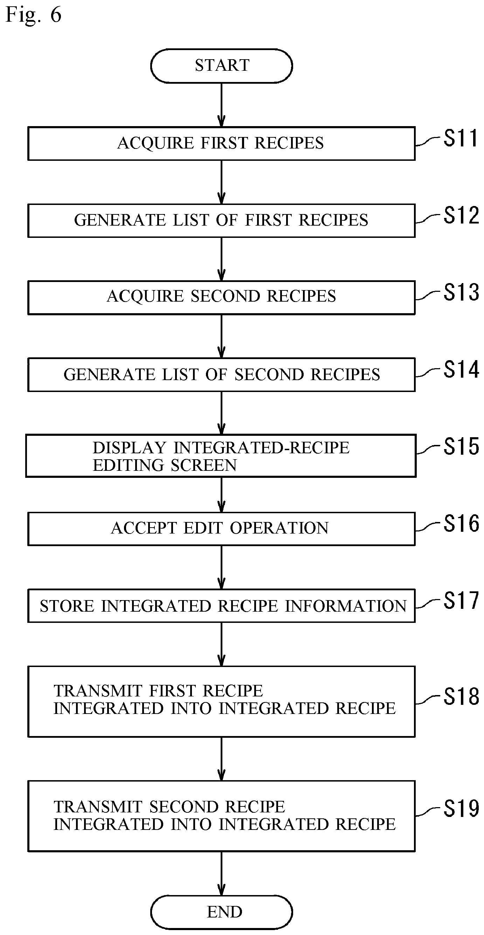

The storage 12 includes a main storage device. The storage 12 may further includes an auxiliary storage device. The storage 12 may includes a removable medium. The storage 12 stores various computer programs and a variety of data. For example, the data may include integrated recipe information HR, which will be described later with reference to Figs. 5 and 6.

The controller 13 includes a processor. The controller 13 may include, for example, a CPU as the processor. The controller 13 may include a GPU as the processor. The controller 13 may include a general-purpose arithmetic unit or a dedicated arithmetic unit. The controller 13 controls the communicator 11 and the storage 12 by executing computer programs stored in the storage 12. When executing the computer programs, the controller 13 may reference data stored in the storage 12.

For example, in the case where the communicator 11 has received a command to create an integrated job, the controller 13 generates a first virtual job and a second virtual job with reference to the integrated recipe information HR. Then, the controller 13 controls the communicator 11 to transmit the first virtual job from the communicator 11 to the first processing apparatus 20. Similarly, the controller 13 controls the communicator 11 to transmit the second virtual job from the communicator 11 to the second processing apparatus 50.

In the case where an event has occurred in which a substrate storage container CA has docked with the first processing apparatus 20, the controller 13 causes the communicator 11 to notify the host computer HC of the occurrence of the event in which the substrate storage container CA has docked with the substrate processing system 1000.

Next, the first processing apparatus 20 is described. As shown in Fig. 1, the first processing apparatus 20 includes a first control device 21 and a main body 30. The main body 30 executes the first processing on substrates W. In the present embodiment, the first processing apparatus 20 is a batch processing apparatus, and the main body 30 executes batch processing on substrates W. The first control device 21 controls the main body 30. Specifically, the first control device 21 includes a first communicator 22, a first storage 23, and a first controller 24.

The first communicator 22 is connected to a network and communicates with the communicator 11 of the integrated control device 10. The first communicator 22 includes communication equipment. The first communicator 22 is controlled by the first controller 24 to notify the integrated control device 10 of the occurrence of an event. The first communicator 22 also receives a first virtual job from the integrated control device 10.

The first storage 23 includes a main storage device. The first storage 23 may further include an auxiliary storage device. The first storage 23 may include a removable medium. The first storage 23 stores various computer programs and a variety of data. For example, the data may include a first recipe RP1. The first recipe RP1 prescribes the first processing that the main body 30 of the first processing apparatus 20 executes on substrates W. To be more specific, the first recipe RP1 prescribes a procedure of substrate processing (process sequence) and set values for various parameters (process parameters).

The first controller 24 includes a processor. The first controller 24 may include, for example, a CPU as the processor. The first controller 24 may include a micro controller unit (MCU), a micro processing unit (MPU), or a GPU as the processor. The first controller 24 may include a general-purpose arithmetic unit or a dedicated arithmetic unit. The first controller 24 controls the first communicator 22, the first storage 23, and the main body 30 by executing computer programs stored in the first storage 23. When executing the computer programs, the first controller 24 may reference data stored in the first storage 23.

Specifically, every time an event occurs in the first processing apparatus 20, the first controller 24 causes the first communicator 22 to notify the integrated control device 10 of the occurrence of the event. For example, every time the status of the main body 30 has changed, the first controller 24 causes the first communicator 22 to notify the integrated control device 10 of the occurrence of the event.

When a first virtual job is received from the integrated control device 10, the first controller 24 controls and causes the main body 30 to process substrates W in accordance with the first recipe RP1. To be more specific, the first storage 23 stores at least one first recipe RP1. The first virtual job includes information for identifying (designating) one of the first recipes RP 1 stored in the first storage 23. The first controller 24 controls the main body 30 with reference to the first recipe RP1 identified (designated) by the first virtual job.

In the present embodiment, the main body 30 executes the chemical solution processing and the rinse processing on substrates W in accordance with the first virtual job. The first recipe RP1 identified (designated) by the first virtual job prescribes a procedure of the chemical solution processing, a procedure of the rinse processing, and set values for various parameters.

Next, the second processing apparatus 50 is described. As shown in Fig. 1, the second processing apparatus 50 includes a second control device 51 and a main body 60. The main body 60 executes second processing on substrates W. In the present embodiment, the second processing apparatus 50 is a sheet-fed processing apparatus, and the main body 60 executes sheet-fed processing on substrates W. The second control device 51 controls the main body 60. Specifically, the second control device 51 includes a second communicator 52, a second storage 53, and a second controller 54.

The second communicator 52 is connected to a network and communicates with the communicator 11 of the integrated control device 10. The second communicator 52 includes communication equipment. The second communicator 52 is controlled by the second controller 54 to notify the integrated control device 10 of the occurrence of an event. The second communicator 52 also receives a second virtual job from the integrated control device 10.

The second storage 53 includes a main storage device. The second storage 53 may further include an auxiliary storage device. The second storage 53 may includes a removable medium. The second storage 53 stores various computer programs and a variety of data. For example, the data may include a second recipe RP2. The second recipe RP2 prescribes the second processing that the main body 60 of the second processing apparatus 50 executes on substrates W. To be more specific, the second recipe RP2 prescribes a procedure of substrate processing (process sequence) and set values for various parameters (process parameters).

The second controller 54 includes a processor. The second controller 54 may include, for example, a CPU as the processor. The second controller 54 may include an MCU, an MPU, or a GPU as the processor. The second controller 54 may include a general-purpose arithmetic unit or a dedicated arithmetic unit. The second controller 54 controls the second communicator 52, the second storage 53, and the main body 60 by executing computer programs stored in the second storage 53. When executing the computer programs, the second controller 54 may reference data stored in the second storage 53.

Specifically, every time an event occurs in the second processing apparatus 50, the second controller 54 causes the second communicator 52 to notify the integrated control device 10 of the occurrence of the event. For example, every time the status of the main body 60 has changed, the second controller 54 causes the second communicator 52 to notify the integrated control device 10 of the occurrence of the event.

When a second virtual job is received from the integrated control device 10, the second controller 54 controls and causes the main body 60 to process substrates W in accordance with the second recipe RP2. To be more specific, the second storage 53 stores at least one second recipe RP2. The second virtual job includes information for identifying (designating) one of the second recipes RP2 stored in the second storage 53. The second controller 54 controls the main body 60 with reference to the second recipe RP2 identified (designated) by the second virtual job.

In the present embodiment, the main body 60 executes the dry processing on substrates W in accordance with the second virtual job. The second recipe RP2 identified (designated) by the second virtual job prescribes a procedure of the dry processing and set values for various parameters.

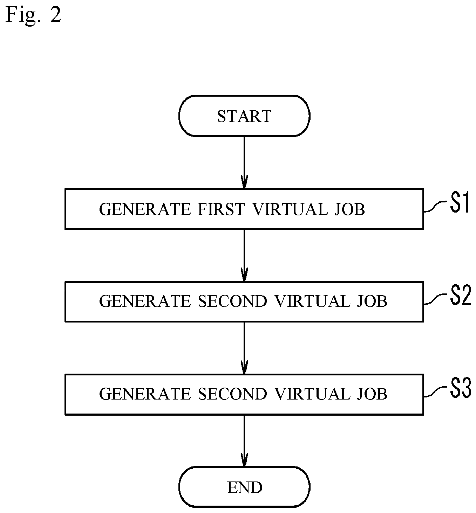

Next, the processing executed by the controller 13 of the integrated control device 10 is described with reference to Figs. 1 and 2. Fig. 2 is a flowchart showing a procedure of the processing executed by the controller 13 of the integrated control device 10 included in the substrate processing system 1000 according to the present embodiment. The processing shown in Fig. 2 is started upon the integrated control device 10 receiving a command to create an integrated job from the host computer HC.

As shown in Fig. 2, the integrated control device 10 generates a first virtual job and a second virtual job in accordance with the command to create an integrated job, received from the host computer HC. To be more specific, upon receipt of the command to create an integrated job from the host computer HC, the integrated control device 10 generates the first virtual job and the second virtual job with reference to the integrated recipe information HR.

Specifically, when the processing shown in Fig. 2 is started, the controller 13 (integrated control device 10) generates the first virtual job with reference to the integrated recipe information HR and transmits the first virtual job from the communicator 11 to the first control device 21 of the first processing apparatus 20 (step S1). As a result, the first processing apparatus 20 executes processing on substrates W in accordance with the first virtual job. In the present embodiment, the first processing apparatus 20 is a batch processing apparatus and executes the chemical solution processing and the rinse processing on a set of lots by one operation.

After the chemical solution processing and the rinse processing of the set of lots is completed, the controller 13 (integrated control device 10) generates a second virtual job with reference to the integrated recipe information HR and transmits the second virtual job from the communicator 11 to the second control device 51 of the second processing apparatus 50 (step S2). As a result, the second processing apparatus 50 executes processing on substrates W in accordance with the second virtual job. In the present embodiment, the second processing apparatus 50 is a sheet-fed processing apparatus and processes substrates W one by one. Specifically, the second processing apparatus 50 executes the dry processing.

The second virtual job is a command to execute processing on substrates W, which configure one lot. Thus, after the dry processing of one lot in the set of lots (two lots) is completed, the controller 13 (integrated control device 10) again generates a second virtual job with reference to the integrated recipe information HR and again transmits the second virtual job from the communicator 11 to the second control device 51 of the second processing apparatus 50 (step S3). As a result, the processing shown in Fig. 2 ends. Note that, in accordance with the secondly generated second virtual job, the second processing apparatus 50 executes the dry processing on the other lot in the set of lots (two lots).

Next, the substrate processing system 1000 according to the present embodiment is described with reference to Fig. 3. Fig. 3 is a plan view schematically showing a configuration of the substrate processing system 1000 according to the present embodiment. To be more specific, Fig. 3 shows configurations of the main body 30 of the batch processing apparatus 20, the main body 60 of the sheet-fed processing apparatus 50, the first coupler 80, and a second coupler 90.

In the following description, X, Y, and Z directions may be defined in order to facilitate understanding. The X and Y directions are directions parallel to a horizontal plane, and the Z direction is a direction parallel to a vertical plane. The X and Y directions are orthogonal to each other. In the present embodiment, the side of the batch processing apparatus 20 on which a plurality of first container placement parts CP1 are located is referred to as the +X side, and the opposite side is referred to as the -X side. Similarly, the side of the sheet-fed processing apparatus 50 on which a plurality of second container placement parts CP2 are located is referred to as the +X side, and the opposite side is referred to as the -X side. Moreover, the side of the batch processing apparatus 20 on which the sheet-fed processing apparatus 50 is located is referred to as the -Y side, and the side of the sheet-fed processing apparatus 50 on which the batch processing apparatus 20 is referred to as the +Y side. Thus, the batch processing apparatus 20 and the sheet-fed processing apparatus 50 are opposed to each other in the Y direction.

As shown in Fig. 3, the main body 30 of the batch processing apparatus 20 includes a first casing 31, a plurality of first container placement parts CP1, a container storage ACB, a first lot transport mechanism HTR, a first orientation conversion mechanism CTC, a second lot transport mechanism WTR, and first to seventh batch processing units BPU1 to BPU7.

The first container placement parts CP1 are provided outside the first casing 31. A substrate storage container CA is placed on each of the first container placement parts CP1. In the present embodiment, the batch processing apparatus 20 includes two first container placement parts CP1. The two first container placement parts CP1 are arranged in the Y direction. The two first container placement parts CP1 are located on the +X side of the container storage ACB.

The first container placement parts CP1 may, for example, be load ports. Hereinafter, one of the two first container placement parts CP1 may be referred to as the "first load port LP1", and the other one may be referred to as the "second load port LP2." The second load port LP2 is located on the -Y side of the first load port LP1. The first load port LP1 is located on the +Y side of the second load port LP2.

The container storage ACB is provided inside the first casing 31. The container storage ACB stores substrate storage containers CA. Specifically, the container storage ACB includes a first container transport mechanism 32, a first container shelf 33a, and a plurality of second container shelves 33b.

The first container transport mechanism 32 is configured to be capable of transporting substrate storage containers CA among the second load port LP2, the first container shelf 33a, and the second container shelves 33b. The operation of the first container transport mechanism 32 is controlled by the first control device 21.

Specifically, the first container transport mechanism 32 is capable of transporting a substrate storage container CA placed on the second load port LP2 to the first container shelf 33a and placing the substrate storage container CA on the first container shelf 33a. The first container transport mechanism 32 is also capable of transporting a substrate storage container CA from the first container shelf 33a to one of the second container shelves 33b and placing the substrate storage container CA on the second container shelf 33b. The first container transport mechanism 32 is also capable of transporting a substrate storage container CA from a second container shelf 33b to the second load port LP2 and placing the substrate storage container CA on the second load port LP2. The first container transport mechanism 32 is also capable of transporting a substrate storage container CAfrom a second container shelf 33b to the first container shelf 33a and placing the substrate storage container CA on the first container shelf 33a. The first container transport mechanism 32 is also capable of transporting a substrate storage container CA from the first container shelf 33a to the second load port LP2 and placing the substrate storage container CA on the second load port LP2.

The first lot transport mechanism HTR and the first orientation conversion mechanism CTC are provided inside the first casing 31. The first lot transport mechanism HTR is configured to access a substrate storage container CA placed on the first container shelf 33a, transport a lot of substrates W out of the substrate storage container CA by one operation, and transport the lot of substrates W to the first orientation conversion mechanism CTC. The first lot transport mechanism HTR and the first orientation conversion mechanism CTC are configured to transfer one lot of substrates W between the first lot transport mechanism HTR and the first orientation conversion mechanism CTC. The operation of the first lot transport mechanism HTR is controlled by the first control device 21.

The first orientation conversion mechanism CTC is configured to combine two lots of substrates W into a set of lots. The first orientation conversion mechanism CTC is also configured to convert the orientation of the set of lots to convert the orientation of each substrate W in the set of lots between a horizontal position and a vertical position. That is, the first orientation conversion mechanism CTC is configured to convert the orientation of the set of lots between a horizontal position and a vertical position. The operation of the first orientation conversion mechanism CTC is controlled by the first control device 21.

Specifically, in response to the first container transport mechanism 32 transporting a first substrate storage container CA1 from the second load port LP2 to the first container shelf 33a, the first lot transport mechanism HTR transports a first lot of substrates W contained in the first substrate storage container CA1 to the first orientation conversion mechanism CTC by one operation.

After transporting the empty first substrate storage container CA1 from the first container shelf 33a to one of the second container shelves 33b, the first container transport mechanism 32 transports a second substrate storage container CA2 that is newly placed on the second load port LP2 to the first container shelf 33a. Then, the first lot transport mechanism HTR transports a second lot of substrates W contained in the second substrate storage container CA2 placed on the first container shelf 33a to the first orientation conversion mechanism CTC by one operation. The first orientation conversion mechanism CTC combines the two lots sequentially transported by the first lot transport mechanism HTR into a set of lots.

The second lot transport mechanism WTR and the first to seventh batch processing units BPU1 to BPU7 are provided inside the first casing 31. The first to seventh batch processing units BPU1 to BPU7 are arranged in the X direction. In the present embodiment, the seventh batch processing unit BPU7 among the first to seventh batch processing units BPU1 to BPU7 is located closest to the +X side.

The second lot transport mechanism WTR and the first orientation conversion mechanism CTC are configured to be capable of transferring a set of lots between the second lot transport mechanism WTR and the first orientation conversion mechanism CTC. The second lot transport mechanism WTR is also configured to be capable of exchanging a set of lots among the first to seventh batch processing units BPU1 to BPU7. The second lot transport mechanism WTR is further configured to be capable of transferring a set of lots to and from a substrate standby part 40, which will be described later. Specifically, the second lot transport mechanism WTR includes a pair of chucks 34 that are configured to be capable of grasping each substrate W of a set of lots in a vertical position. The operation of the second lot transport mechanism WTR is controlled by the first control device 21.

The first to fourth batch processing units BPU1 to BPU4 are each configured to be capable of executing the chemical solution processing on each substrate W of a set of lots oriented in a vertical position by one operation (batch chemical solution processing). Thus, the batch processing apparatus 20 is capable of executing the chemical solution processing on a maximum of four sets of lots (i.e., eight lots) in parallel. The second lot transport mechanism WTR grasps a set of lots supported by the first orientation conversion mechanism CTC by the pair of chucks 34 and then transports the set of lots to one of the first to fourth batch processing units BPU1 to BPU4.

Specifically, the first batch processing unit BPU1 includes a first chemical solution tank CHB1 and a first lifter LF1, the second batch processing unit BPU2 includes a second chemical solution tank CHB2 and a second lifter LF2, the third batch processing unit BPU3 includes a third chemical solution tank CHB3 and a third lifter LF3, and the fourth batch processing unit BPU4 includes a fourth chemical solution tank CHB4 and a fourth lifter LF4.

The first chemical solution tank CHB1 stores a chemical solution. The chemical solution may, for example, be an etchant. The etchant may, for example, be an acidic chemical solution such as a phosphate solution. The first lifter LF1 is configured to be movable up and down between a upper position and a lower position. The upper position is a position above the liquid level of the chemical solution stored in the first chemical solution tank CHB1, and the lower position is a position below the liquid level of the chemical solution stored in the first chemical solution tank CHB1. The operation of the first lifter LF1 is controlled by the first control device 21.

When the first lifter LF1 is in the upper position, a set of lots is transferred to and from the second lot transport mechanism WTR. Specifically, the first lifter LF1 includes a support member 35. The support member 35 supports each substrate W in a vertical position. When the first lifter LF1 is located in the upper position, the second lot transport mechanism WTR places a set of lots on the support member 35 of the first lifter LF1. When the first lifter LF1 is located in the upper position, the second lot transport mechanism WTR also grasps each substrate W supported in a vertical position by the support member 35 of the first lifter LF1 by the pair of chucks 34.

When the first lifter LF1 moves from the upper position to the lower position while each substrate W is supported in a vertical position by the support member 35, the substrate W is immersed in a vertical position in the chemical solution stored in the first chemical solution tank CHB1. Each substrate W held in the chemical solution is processed using the chemical solution. After the chemical solution processing is completed, the first lifter LF1 moves from the lower position to the upper position.

The configurations of the second to fourth batch processing units BPU2 to BPU4 are the same as the configuration of the first batch processing unit BPU1, and therefore descriptions thereof shall be omitted.

The fifth and sixth batch processing units BPU5 and BPU6 are each configured to be capable of executing the rinse processing on each substrate W of a set of lots oriented in a vertical position by one operation (batch rinse processing). Thus, the batch processing apparatus 20 is capable of executing the rinse processing on a maximum of two sets of lots (i.e., four lots) in parallel. The second lot transport mechanism WTR transports a set of lots that has undergone the chemical solution processing to one of the fifth batch processing unit BPU5 and the sixth batch processing unit BPU6.

Specifically, the fifth batch processing unit BPU5 includes a first rinse tank ONB1 and a fifth lifter LF5. The sixth batch processing unit BPU6 includes a second rinse tank ONB2 and a sixth lifter LF6.

The first and second rinse tanks ONB1 and ONB2 store a rinsing liquid. The rinsing liquid may be deionized water (DIW). When a set of lots that has undergone the chemical solution processing is immersed in the rinsing liquid, the chemical solution adhering to each substrate W of the set of lots oriented in a vertical position is washed away. The configurations of the fifth and sixth batch processing units BPU5 and BPU6 are approximately the same as those of the first to fourth batch processing units BPU1 to BPU4, and therefore detailed descriptions thereof shall be omitted.

The seventh batch processing unit BPU7 executes batch dry processing for drying each substrate W of a set of lots oriented in a vertical position by one operation. The seventh batch processing unit BPU7 is used to execute the chemical solution processing, the rinse processing, and the dry processing in the batch processing apparatus 20. The operation of the seventh batch processing unit BPU7 is controlled by the first control device 21.

Specifically, the seventh batch processing unit BPU7 includes a dry chamber LPD, an inert-gas supply nozzle, and an organic-solvent supply nozzle. The second lot transport mechanism WTR stores a set of lots that has undergone the rinse processing in the dry chamber LPD. The inert-gas supply nozzle supplies an inert gas into the dry chamber LPD. The organic-solvent supply nozzle supplies steam of an organic solvent into the dry chamber LPD. Note that the inert gas may, for example, be nitrogen. The organic solvent may, for example, be isopropyl alcohol (IPA).

After a set of lots is contained in the dry chamber LPD, the seventh batch processing unit BPU7 firstly supplies the inert gas into the dry chamber LPD to replace the atmosphere in the dry chamber LPD with the inert gas. Thereafter, the seventh batch processing unit BPU7 reduces the pressure inside the dry chamber LPD. Then, while the dry chamber LPD is maintained in a reduced-pressure condition, the seventh batch processing unit BPU7 supplies steam of the organic solvent into the dry chamber LPD. The organic solvent is discharged to the outside of the dry chamber LPD, along with moisture adhering to each substrate W. As a result, each substrate W contained in the dry chamber LPD is dried.

Note that the first and second lots in the set of lots may be returned to the first and second substrate storage containers CA1 and CA2 after the execution of the dry processing.

Specifically, the second lot transport mechanism WTR transports a set of lots that has undergone the dry processing to the first orientation conversion mechanism CTC. The first orientation conversion mechanism CTC converts the orientation of each substrate W from the vertical position to the horizontal position. Meanwhile, the first container transport mechanism 32 moves the empty first substrate storage container CA1 from the second container shelf 33b to the first container shelf 33a.

The first lot transport mechanism HTR transports one (first lot) of the two lots in a set of lots from the first orientation conversion mechanism CTC to and into the empty first substrate storage container CA1 placed on the first container shelf 33a. As a result, the first lot is contained in the first substrate storage container CA1. The first container transport mechanism 32 transports the first substrate storage container CA1 that contains the first lot having undergone the dry processing to the second load port LP2 and then moves the empty second substrate storage container CA2 from the second container shelf 33b to the first container shelf 33a. The first substrate storage container CA1 placed on the second load port LP2 is transported from the second load port LP2 to the first load port LP1 by a second container transport mechanism 92, which will be described later.

Like the first lot, the second lot that has undergone the dry processing is transported into the empty second substrate storage container CA2. Then, like the first substrate storage container CA1, the second substrate storage container CA2 that contains the second lot having undergone the dry processing is transported to the second load port LP2 by the first container transport mechanism 32.

Meanwhile, in the case where the batch processing apparatus 20 does not execute the batch dry processing, the second lot transport mechanism WTR transports a set of lots that has undergone the rinse processing to the first coupler 80. Specifically, the second lot transport mechanism WTR transports a set of lots that has undergone the rinse processing to the substrate standby part 40 described later. The set of lots that has undergone the rinse processing waits in the substrate standby part 40. Note that the set of lots that has undergone the rinse processing is one example of "substrates that have undergone at least part of first processing."

Next, the first coupler 80 is described. As shown in Fig. 3, the first coupler 80 includes the substrate standby part 40. The substrate standby part 40 is provided within the first casing 31 of the batch processing apparatus 20. In the present embodiment, the substrate standby part 40 is provided on the +X side of the seventh batch processing unit BPU7.

In the case where the batch processing apparatus 20 and the sheet-fed processing apparatus 50 execute the substrate processing, the substrate standby part 40 causes a set of lots that has undergone the rinse processing to wait in the substrate standby part 40. Specifically, the substrate standby part 40 includes a seventh lifter LF7, a standby tank 42, a chuck mechanism TFC, and an orientation converter 43.

The standby tank 42 may store, for example, deionized water. The seventh lifter LF7 is configured to be movable up and down between an upper position and a lower position, like the first lifter LF1. The operation of the seventh lifter LF7 is controlled by the controller 13 (see Fig. 1) of the integrated control device 10. Note that the integrated control device 10 may be arranged, for example, below the second container placement parts CP2 described later.

To be more specific, when the second lot transport mechanism WTR has placed a set of lots on the support member 35 of the seventh lifter LF7 located in the upper position, the first control device 21 (first controller 24) notifies the integrated control device 10 of the occurrence of a completed event of the first virtual job. The completed event indicates that the processing based on the job is completed. In response to the occurrence of the completed event of the first virtual job, the controller 13 of the integrated control device 10 starts to control the first coupler 80.

Specifically, upon the occurrence of the completed event of the first virtual job, the seventh lifter LF7 moves from the upper position to the lower position. As a result, a set of lots (each substrate W oriented in a vertical position) is immersed in deionized water stored in the standby tank 42. The configuration of the seventh lifter LF7 is similar to that of the first lifter LF1, and therefore a detailed description thereof shall be omitted.

The chuck mechanism TFC is configured to transport one lot between the seventh lifter LF7 and the orientation converter 43. Specifically, the chuck mechanism TFC includes a pair of chucks 41 that are configured to be capable of grasping one of the two lots in a set of lots. The operation of the chuck mechanism TFC is controlled by the controller 13 of the integrated control device 10.

While a set of lots is immersed in the solution stored in the standby tank 42, the chuck mechanism TFC grasps one of the two lots in the set of lots supported by the seventh lifter LF7 and transports the one lot to the orientation converter 43. To be more specific, the chuck mechanism TFC grasps one of the two lots by the pair of chucks 41, moves the one lot to above the liquid level of the standby tank 42, and then transports the one lot to the orientation converter 43. After each substrate W of the one lot is transported from the orientation converter 43 to the sheet-fed processing apparatus 50 by the substrate transport mechanism 82 described later, the chuck mechanism TFC grasps the other lot immersed in the solution stored in the standby tank 42 and transports the other lot to the orientation converter 43.

The orientation converter 43 includes a second orientation conversion mechanism and an immersion tank. The second orientation conversion mechanism is configured to be capable of transferring each substrate W of one lot oriented in a vertical position to and from the chuck mechanism TFC. The second orientation conversion mechanism is also configured to convert the orientation of each substrate W of the one lot from the vertical position to the horizontal position. The operation of the second orientation conversion mechanism is controlled by the controller 13 of the integrated control device 10.

The immersion tank may store, for example, deionized water. The second orientation conversion mechanism is configured to be movable in the up-down direction, and downward movement of the second orientation conversion mechanism causes each substrate W in one lot to be immersed in deionized water stored in the immersion tank. The second orientation conversion mechanism further adjusts the position in the up-down direction of each substrate W whose orientation has been converted, so that the uppermost substrate W among substrates W of one lot will be located above the liquid level in the immersion tank. Note that the second orientation conversion mechanism may convert the orientation of one lot in the solution stored in the immersion tank, or may convert the orientation of one lot above the liquid level of the immersion tank.

Next, the sheet-fed processing apparatus 50 is described. As shown in Fig. 3, the main body 60 of the sheet-fed processing apparatus 50 includes a second casing 61, a plurality of second container placement parts CP2, an indexer robot IR, a center robot CR, and a plurality of towers TW. Moreover, the first coupler 80 includes a transferer 62.

The second container placement parts CP2 are provided outside the second casing 61. Specifically, the second container placement parts CP2 are located on the +X side of the second casing 61. A substrate storage container CA is placed on each of the second container placement parts CP2. The second container placement parts CP2 are aligned in the Y direction.

In the present embodiment, the sheet-fed processing apparatus 50 includes four second container placement parts CP2. The second container placement parts CP2 may, for example, be load ports. Hereinafter, the second container placement parts CP2 may also be referred to as the "third load ports LP3."

The indexer robot IR, the center robot CR, and the towers TW are located within the second casing 61. The indexer robot IR transports substrates W between each third load port LP3 and the center robot CR. The apparatus may also be configured such that a placement base (path) for temporarily placing substrates W may be provided between the indexer robot IR and the center robot CR, and substrates W may be transferred indirectly between the indexer robot IR and the center robot CR via the placement base. The operation of the indexer robot IR is controlled by the second control device 51.

The towers TW are arranged to surround the center robot CR in plan view. In the present embodiment, the sheet-fed processing apparatus 50 includes four towers TW (first to fourth towers TW1 to TW4).

Each tower TW includes a plurality of sheet-fed processing units 63 vertically stacked one above another. In the present embodiment, each of the first, second, and fourth towers TW1, TW2, and TW4 includes three sheet-fed processing units 63. The third tower TW3 includes two sheet-fed processing units 63 and one chamber 63a. To be more specific, the sheet-fed processing unit 63 is provided on the top and bottom of the third tower TW3. The chamber 63a is provided in the middle of the third tower TW3. Fig. 3 shows a configuration of the middle of each tower TW.

The center robot CR transports substrates W between the indexer robot IR and the sheet-fed processing units 63. The center robot CR also transports substrates W between the chamber 63a and the sheet-fed processing units 63. The operation of the center robot CR is controlled by the second control device 51.

Each sheet-fed processing unit 63 is configured to be capable of executing the chemical solution processing, the rinse processing, and the dry processing on one substrate W. The transferer 62 of the first coupler 80 is provided inside the chamber 63a. Specifically, the chamber 63a has an approximately box-like shape and contains the transferer 62 therein.

The transferer 62 is configured to hold substrates W one by one. For example, the transferer 62 may be a holding chuck or a vacuum chuck. The operation of the transferer 62 is controlled by the controller 13 (see Fig. 1) of the integrated control device 10.

Next, the batch processing apparatus 20, the sheet-fed processing apparatus 50, and the first coupler 80 are further described in detail with reference to Fig. 3. As shown in Fig. 3, the first casing 31 of the batch processing apparatus 20 has a first opening 31a. The second casing 61 of the sheet-fed processing apparatus 50 has a second opening 61a. The first coupler 80 further includes a first coupler casing 81 and the substrate transport mechanism 82.

The first coupler casing 81 has a tube-like shape. The first coupler casing 81 extends in the Y direction. One end of the first coupler casing 81 is connected to the first casing 31. The other end of the first coupler casing 81 is connected to the second casing 61. One and the other ends of the first coupler casing 81 are open, so that the interior space of the first coupler casing 81 is in communication with the first opening 31a of the first casing 31 and the second opening 61a of the second casing 61.

To be more specific, the first opening 31a of the first casing 31 is provided in a position that allows communication between the interior space of the substrate standby part 40 and the interior space of the first coupler casing 81. The second opening 61a of the second casing 61 is provided in a position that allows communication between the interior space of the chamber 63a and the interior space of the first coupler casing 81.

The substrate transport mechanism 82 transports substrates W processed by the batch processing apparatus 20 one by one to the sheet-fed processing apparatus 50. To be more specific, the substrate transport mechanism 82 accesses the substrate standby part 40 via the first opening 31a of the first casing 31 and transports substrates W that are waiting in the substrate standby part 40 one by one to the sheet-fed processing apparatus 50. The substrate transport mechanism 82 may, for example, be a transport robot. The operation of the substrate transport mechanism 82 is controlled by the controller 13 of the integrated control device 10.

Specifically, the substrate transport mechanism 82 transports substrates W that are located above the liquid level of the immersion tank provided in the orientation converter 43 to the sheet-fed processing apparatus 50. Thus, the substrate transport mechanism 82 transports wet substrates W. Therefore, it is difficult to dry the substrate W during transport by the substrate transport mechanism 82. As a result, for example, even if the substrates W have a fine pattern formed thereon, the pattern on each substrate W is unlikely to be broken during transport of the substrates W by the substrate transport mechanism 82.

In response to the uppermost substrate W being transported by the substrate transport mechanism 82, the second orientation conversion mechanism adjusts the position in the up-down direction of each substrate W whose orientation has been converted and that is held by the second orientation conversion mechanism, such that the next uppermost substrate W is located above the liquid level of the immersion tank.

The substrate transport mechanism 82 transports out substrates W processed by the batch processing apparatus 20 from the first opening 31a of the first casing 31, transports the substrates W through the interior of the first coupler casing 81, and transports the substrates W into the second casing 61 from the second opening 61a of the second casing 61. To be more specific, the substrate transport mechanism 82 transports substrates W into the chamber 63a through the second opening 61a. Then, the substrate transport mechanism 82 transfers the substrates W to the transferer 62. The transferer 62 holds the substrates W transferred from the substrate transport mechanism 82.

When substrates W are held by the transferer 62, the controller 13 of the integrated control device 10 notifies the sheet-fed processing apparatus 50 of the fact that the substrates W are held by the transferer 62. When this notification is received by the sheet-fed processing apparatus 50, the center robot CR accesses the chamber 63a, takes the substrates W out of the chamber 63a, and transports the substrates W into one of the sheet-fed processing units 63.

As described above, the substrate processing system 1000 according to Embodiment 1 includes the first coupler 80. As a result, a dedicated transport path for transporting substrates W is formed between the first processing apparatus 20 and the second processing apparatus 50. This eliminates, for example, the need to return wet substrates W to a substrate storage container CA and transport the substrate storage container CA that contains the wet substrates W from a first container placement part CP1 of the first processing apparatus 20 to a second container placement part CP2 of the second processing apparatus 50.

Next, the substrate processing system 1000 according to the present embodiment is further described in detail with reference to Fig. 3. As shown in Fig. 3, the substrate processing system 1000 further includes the second coupler 90. The second coupler 90 couples the batch processing apparatus 20 and the sheet-fed processing apparatus 50. The second coupler 90 includes a second coupler casing 91 and the second container transport mechanism 92.

The second coupler casing 91 has a tube-like shape. The second coupler casing 91 extends in the Y direction. The second coupler casing 91 covers the first container placement parts CP1 of the first processing apparatus 20 and the second container placement parts CP2 of the second processing apparatus 50. The second container transport mechanism 92 is configured to transport substrate storage containers CA. For example, the second container transport mechanism 92 transports a substrate storage container CA placed on a first container placement part CP1 of the first processing apparatus 20 to a second container placement part CP2 of the second processing apparatus 50. To be more specific, the second container transport mechanism 92 transports a substrate storage container CA through the interior of the second coupler casing 91. The operation of the second container transport mechanism 92 is controlled by the controller 13 (see Fig. 1) of the integrated control device 10.

In the present embodiment, the second coupler casing 91 convers the second load port LP2 of the first processing apparatus 20 and the third load ports LP3 of the second processing apparatus 50. Thus, the second load port LP2 and the third load ports LP3 are located inside the second coupler casing 91, and the first load port LP1 of the first processing apparatus 20 is located outside the second coupler casing 91. The first load port LP1 receives a substrate storage container CA to be placed thereon, by an overhead hoist transport (OHT). An in-plant transport system such as an OHT transports substrate storage containers CA within a clean room where the first processing apparatus 20 and the second processing apparatus 50 are located.

The +Y-side end of the second coupler casing 91 (the end on the side of the first load port LP1) is located between the first load port LP1 and the second load ports LP2. The +Y-side end of the second coupler casing 91 is open. Hereinafter, the +Y-side end of the second coupler casing 91 may also be referred to as "one end of the second coupler casing 91." The -Y-side end of the second coupler casing 91 opposite to the one end thereof may also be referred to as the "other end of the second coupler casing 91."

The second container transport mechanism 92 transports a substrate storage container CA placed on the first load port LP1 from the outside of the second coupler casing 91 to the inside thereof via the one end (the +Y-side end) of the second coupler casing 91 and places the substrate storage container CA on the second load port LP2. The second container transport mechanism 92 transports the empty substrate storage container CA placed on the second load port LP2 by the first container transport mechanism 32 to one of the four third load ports LP3 and places the substrate storage container CA on the third load port LP3.

The second coupler casing 91 has a ceiling wall having an opening (not shown). For example, the opening formed in the ceiling wall of the second coupler casing 91 may be located in the vicinity of the other end (the -Y-side end) of the second coupler casing 91. Note that the other end (the -Y-side end) of the second coupler casing 91 is located further on the -Y side than the third load port LP3 that is located most on the -Y side among the four third load ports LP3.

The second container transport mechanism 92 is configured to be movable up and down. The second container transport mechanism 92 moves up a substrate storage container CA that contains substrates W having undergone the dry processing executed by the sheet-fed processing apparatus 50 toward the opening formed in the ceiling wall of the second coupler casing 91.

For example, the opening formed in the ceiling wall of the second coupler casing 91 may be formed accessible by the OHT. In this case, the OHT receives a substrate storage container CA from the second container transport mechanism 92 through the opening formed in the ceiling wall of the second coupler casing 91 and transports the substrate storage container CA to the outside of the second coupler casing 91. Alternatively, the second container transport mechanism 92 may move up a substrate storage container CAto above the ceiling wall of the second coupler casing 91 through the opening formed in the ceiling wall of the second coupler casing 91.

As described above, the substrate processing system 1000 according to Embodiment 1 includes the second coupler 90. As a result, a dedicated transport path for transporting substrate storage containers CA is formed between the first processing apparatus 20 and the second processing apparatus 50. This eliminates the need to use an in-plant transport system such as an OHT for the transport of substrate storage containers CA between the first processing apparatus 20 and the second processing apparatus 50.

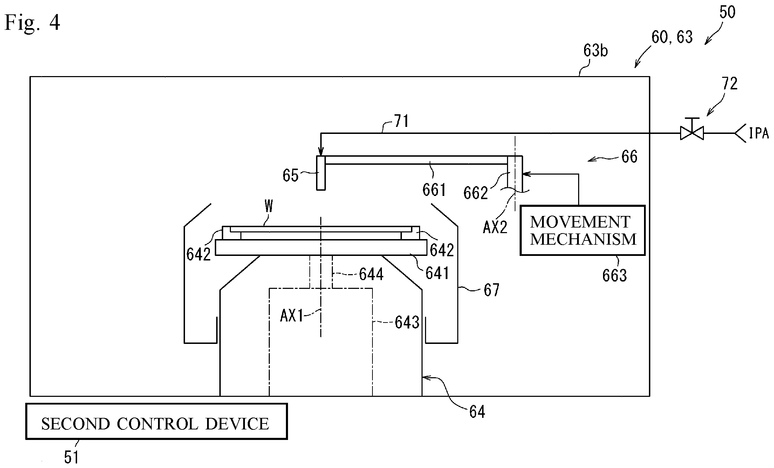

Next, the sheet-fed processing units 63 are described with reference to Fig. 4. Fig. 4 is a side sectional view schematically showing the interior of one sheet-fed processing unit 63. As shown in Fig. 4, the sheet-fed processing unit 63 includes a chamber 63b, a spin chuck 64, a nozzle 65, a nozzle mover 66, and a cup 67. The sheet-fed processing apparatus 50 further includes a liquid supply line 71and an on-off valve 72.

A substrate W is transported into the chamber 63b and processed inside the chamber 63b. The chamber 63b has an approximately box-like shape. The chamber 63b houses the spin chuck 64, the nozzle 65, the nozzle mover 66, the cup 67, and part of the liquid supply line 71.

The spin chuck 64 holds a substrate W horizontally. The spin chuck 64 rotates a substrate W about a first rotation axis AX1 that extends in the vertical direction. Specifically, the spin chuck 64 includes a spin base 641, a plurality of chuck members 642, a motor body 643, and a shaft 644.

The spin base 641 has a disc-like shape and supports the chuck members 642 in a horizontal position. The chuck members 642 are arranged on the periphery of the spin base 641. The chuck members 642 holds the periphery of a substrate W. The chuck members 642 allow a substrate W to be held in a horizontal position. The operation of the chuck members 642 is controlled by the second control device 51. The chuck members 642 are arranged such that the center of a substrate W faces the center of the spin base 641.

The shaft 644 is coupled to the center of the spin base 641. The shaft 644 extends vertically downward along the first rotation axis AX1 from the center of the spin base 641. The motor body 643 rotates the shaft 644 about the first rotation axis AX1. As a result, the spin base 641 is rotated, and the substrate W held by the chuck members 642 is rotated about the first rotation axis AX1. The operation of the motor body 643 is controlled by the second control device 51. The motor body 643 may, for example, be an electric motor.

The nozzle mover 66 moves the nozzle 65 in the vertical direction and in the horizontal direction. Specifically, the nozzle mover 66 includes an arm 661, a base 662, and a nozzle movement mechanism 663.

The base 662 extends in the vertical direction. The arm 661 is coupled to the base 662. The arm 661 extends in the horizontal direction from the base 662. The arm 661 supports the nozzle 65. For example, the nozzle 65 may be fixed to the tip end of the arm 661.

The nozzle movement mechanism 663 moves the arm 661 in the vertical direction and in the horizontal direction. As a result, the nozzle 65 moves in the vertical direction and in the horizontal direction. The nozzle movement mechanism 663 is controlled by the second control device 51.

Specifically, the nozzle movement mechanism 663 includes a rotation mechanism and an elevating mechanism. The rotation mechanism rotates the base 662 in both reciprocal directions about a second rotation axis AX2 extending in the vertical direction. As a result, the nozzle 65 moves along a horizontal plane. The elevating mechanism moves the base 662 up and down in the vertical direction. As a result, the nozzle 65 moves in the vertical direction. The actuator of the rotation mechanism may include, for example, a servomotor such as a stepping motor, and a speed reducer. The actuator of the elevating mechanism may include, for example, a ball screw and an electric motor that is rotatable in both reciprocal directions.

The nozzle mover 66 moves the nozzle 65 between a processing position and a retracted position. The processing position refers to a position that is opposite to the center of a substrate W. The retracted position is a position located outward of the cup 67 in plan view.

The nozzle 65 ejects a processing fluid from the processing position toward the upper surface of a substrate W held by the spin chuck 64. More specifically, the nozzle 65 ejects a processing fluid toward the center of a rotating substrate W. As a result, a liquid membrane of the processing fluid is formed on the upper surface of the substrate W. In the present embodiment, the nozzle 65 ejects IPA. The IPA is one example of an organic solvent.

The dry processing executed by the sheet-fed processing unit 63 is described herein. As described with reference to Fig. 3, a substrate W that has undergone the chemical solution processing and the rinse processing executed by the batch processing apparatus 20 may be transported to the sheet-fed processing apparatus 50. In this case, the center robot CR transports the substrate W from the transferer 62 to one of the sheet-fed processing units 63. The spin chuck 64 holds and rotates the substrate W transported into the chamber 63b. Thereafter, IPAis supplied from the nozzle 65 toward the rotating substrate W. As a result, the rinsing liquid adhering to the substrate W is washed away, and a liquid membrane of IPA is formed on the upper surface of the substrate W. After a predetermined period of time has elapsed since the start of ejection of IPA, the spin chuck 64 increases the rotational speed of the substrate W As a result, IPA scatters from the upper surface of the substrate W, and the substrate W is dried.

Then, the liquid supply line 71, the on-off valve 72, and the cup 67 are described. The liquid supply line 71 supplies a processing fluid to the nozzle 65. The liquid supply line 71 is a tube-like member for circulating the processing fluid. When the processing fluid is supplied through the liquid supply line 71 to the nozzle 65, the processing fluid is ejected from the nozzle 65. In the present embodiment, the liquid supply line 71 supplies IPA to the nozzle 65.

The on-off valve 72 is provided in the liquid supply line 71. The on-off valve 72 is switchable between an open state and a closed state. The second control device 51 controls an opening and closing operation of the on-off valve 72. Specifically, when a processing fluid (IPA) is supplied from the nozzle 65 to a substrate W, the second control device 51 brings the on-off valve 72 into the open state. As a result, the processing fluid (IPA) circulates through the liquid supply line 71 toward the nozzle 65 and is ejected from the nozzle 65 toward the substrate W. In the case of stopping the ejection of the processing fluid (IPA) from the nozzle 65, the second control device 51 brings the on-off valve 72 into the closed state. As a result, the circulation of the processing fluid (IPA) through the liquid supply line 71 is stopped, and the ejection of the processing fluid (IPA) from the nozzle 65 is stopped.

The cup 67 is arranged outward of the spin chuck 64. The cup 67 has an approximately tube-like shape. In other words, the cup 67 surrounds the spin chuck 64. The cup 67 receives the processing fluid discharged from the substrate W so as to prevent the processing fluid from scattering to the interior of the chamber 63b.

Note that the sheet-fed processing unit 63 may include at least one nozzle in addition to the nozzle 65. For example, the sheet-fed processing unit 63 may include a chemical solution nozzle and a rinsing liquid nozzle in addition to the nozzle 65. The chemical solution nozzle ejects a chemical solution toward the upper surface of the substrate W when the sheet-fed processing unit 63 executes the chemical solution processing. The rinsing liquid nozzle ejects the rinsing liquid toward the upper surface of the substrate W when the sheet-fed processing unit 63 executes the rinsing processing.

Next, the first recipe editing screen G1 is described with reference to Figs. 1 and 5. Fig. 5 is a diagram showing one example of the first recipe editing screen G1. The first recipe editing screen G1 is a screen for editing (creating) an integrated recipe. The integrated recipe indicates a recipe created by integrating a first recipe RP1 and a second recipe RP2 with each other. A user of the substrate processing system 1000 edits (creates) an integrated recipe via the first recipe editing screen G1 before processing substrates W by using the substrate processing system 1000.

The first recipe editing screen G1 is displayed on the display HC2 of the host computer HC by the integrated control device 10. As shown in Fig. 5, the first recipe editing screen G1 displays a recipe name field 101, a first recipe list field 102, and a second recipe list field 103.

The recipe name field 101 is an input field for setting the name of the integrated recipe. An operator of the host computer HC is able to set the name of the integrated recipe by operating the input device HC1 to input arbitrary characters, symbols, or numerals in the recipe name field 101.

The first recipe list field 102 displays a list of the names of first recipes RP1 stored in the first storage 23 of the first processing apparatus 20. For example, in the case where the first storage 23 stores a plurality of first recipes RP1, the first recipe list field 102 displays the names of the first recipes RP1 in list format. By operating the input device HC1, the operator of the host computer HC is able to designate (select) a first recipe RP1 that is to be integrated into the integrated recipe from among the first recipes RP1 displayed in the first recipe list field 102.

When the operator of the host computer HC has designated (selected) one of the first recipes RP1 displayed in the first recipe list field 102 by operating the input device HC1, a first individual recipe editing screen (not shown) is displayed on the display HC2.

The first individual recipe editing screen is a screen for editing the first recipe RP1 designated (selected) by the operator. In the case where the batch processing apparatus 20 is an existing device, existing first recipes RP1 stored in the first storage 23 prescribe the procedures of the chemical solution processing, the rinse processing, and the dry processing and set values for various parameters relating to each processing. For example, in the case of creating an integrated recipe, the operator may edit a first recipe RP1 via the first individual recipe editing screen such that, from among the chemical solution processing, the rinse processing, and the dry processing, the chemical solution processing and the rinse processing are executed by the batch processing apparatus 20.

Like the first recipe list field 102, the second recipe list field 103 displays a list of the names of second recipes RP2 stored in the second storage 53 of the second processing apparatus 50. By operating the input device HC1, the operator of the host computer HC is able to designate (select) a second recipe RP2 that is to be integrated into the integrated recipe from among the second recipes RP2 displayed in the second recipe list field 103.

When the operator of the host computer HC has designated (selected) one of the names of the second recipes RP2 displayed in the second recipe list field 103 by operating the input device HC1, a second individual recipe editing screen (not shown) is displayed on the display HC2 as in the case where the first recipe RP1 has been designated (selected).

Like the first individual recipe editing screen, the second individual recipe editing screen is a screen for editing the second recipe RP2 designated (selected) by the operator. For example, in the case of creating an integrated recipe, the operator may edit the second recipe RP2 via the second individual recipe editing screen such that only the dry processing is executed by the sheet-fed processing apparatus 50 from among the chemical solution processing, the rinse processing, and the dry processing.

Next, integrated-recipe editing processing executed by the controller 13 of the integrated control device 10 is described with reference to Figs. 1, 5, and 6. Fig. 6 is a flowchart showing a procedure of the integrated recipe editing processing executed by the controller 13 of the integrated control device 10 included in the substrate processing system 1000 according to the present embodiment. As shown in Fig. 6, the integrated-recipe editing processing involves steps S11 to S19. For example, the integrated-recipe editing processing may be started in response to the operator issuing a command to edit an integrated recipe by operating the input device HC1 of the host computer HC.

When the integrated-recipe editing processing is started, the controller 13 acquires first recipes RP1 from the first processing apparatus 20 via the communicator 11 (step S11). To be more specific, the controller 13 commands the first controller 24 of the first processing apparatus 20 to transmit first recipes RP1. The first controller 24 reads out the first recipes RP1 (recipe files) from the first storage 23 in accordance with the command received from the integrated control device 10. The first controller 24 transmits the first recipes RP1 (recipe files) read out from the first storage 23 to the integrated control device 10 via the first communicator 22. As a result, the communicator 11 of the integrated control device 10 receives the first recipes RP1 (recipe files) from the first processing apparatus 20, and the controller 13 acquires the first recipes RP1 (recipe files) via the communicator 11. The controller 13 stores the first recipes RP1 (recipe files) transmitted from the first processing apparatus 20 in the storage 12.

When the first recipes RP1 are acquired, the controller 13 generates (creates) a list of the first recipes RP1 and stores list data of the first recipes RP1 in the storage 12 (step S12).

As in step S11, the controller 13 also acquires second recipes RP2 from the second processing apparatus 50 via the communicator 11 (step S13). The controller 13 stores the second recipes RP2 transmitted from the second processing apparatus 50 in the storage 12.

When the second recipes RP2 are acquired, the controller 13 generates (creates) a list of the second recipes RP2 and stores list data of the second recipes RP2 in the storage 12 (step S14).

When the list of the first recipes RP1 and the list of the second recipes RP2 have been generated (created), the controller 13 causes the display HC2 of the host computer HC to display the first recipe editing screen G1 (see Fig. 5) (step S15). In the case of displaying the first recipe editing screen G1, the controller 13 makes reference to the list data of the first recipes RP1 and displays a list of the first recipes RP1 in the first recipe list field 102. Similarly, the controller 13 makes reference to the list data of the second recipes RP2 and displays a list of the second recipes RP2 in the second recipe list field 103.

After having displayed the first recipe editing screen G1, the controller 13 accepts an operator's operation of editing an integrated recipe via the first recipe editing screen G1 as described with reference to Fig. 5 (step S16). As a result, the controller 13 edits an integrated recipe that integrates the first recipe RP1 and the second recipe RP2 both designated (selected) by the operator with each other, and stores the integrated recipe information HR (see Fig. 1) in the storage 12 (step S17).

To be more specific, in the case where the first processing apparatus 20 is caused to execute part of the first processing as described with reference to Fig. 5, the controller 13 edits the first recipe RP1 at the time of editing the integrated recipe, so that part of the first processing is executed in accordance with the command received from the host computer HC. Accordingly, the edited first recipe RP1 is integrated into the integrated recipe. In the present embodiment, the first processing executed by the first processing apparatus 20 includes the chemical solution processing, the rinse processing, and the dry processing. At the time of editing the integrated recipe, the controller 13 edits the first recipe RP1 so that, from among the chemical solution processing, the rinse processing, and the dry processing, the chemical solution processing and the rinse processing are executed in response to the operator operating the input device HC1.

Similarly, in the case where the second processing apparatus 50 is caused to execute part of the second processing, the controller 13 edits the second recipe RP2 at the time of editing the integrated recipe, so that part of the second processing is executed in accordance with the command received from the host computer HC. Accordingly, the edited second recipe RP2 is integrated into the integrated recipe. In the present embodiment, the second processing executed by the second processing apparatus 50 includes the chemical solution processing, the rinse processing, and the dry processing. At the time of editing the integrated recipe, the controller 13 edits the second recipe RP2 so that, from among the chemical solution processing, the rinse processing, and the dry processing, only the dry processing is executed in response to the operator operating the input device HC1.

The integrated recipe information HR includes information for identifying the integrated recipe, and information for identifying each of the first and second recipes RP1 and RP2 that are integrated into the integrated recipe. For example, the integrated recipe information HR may include information that indicates the name set for the integrated recipe, and information indicating the names set for the first and second recipes RP1 and RP2, which are integrated into the integrated recipe.

After the integrated recipe information HR is stored in the storage 12, the controller 13 transmits the first recipe RP1 integrated into the integrated recipe to the first processing apparatus 20 (step S18). When the first communicator has received the first recipe RP1 from the integrated control device 10, the first controller 24 of the first processing apparatus 20 modifies (overwrites) the first recipe RP1 stored in the first storage 23 into (with) the first recipe RP1 transmitted from the integrated control device 10. Accordingly, the first recipe RP1 stored in the first storage 23 is modified into the edited first recipe RP1.

Similarly, the controller 13 transmits the second recipe RP2 integrated into the integrated recipe to the second processing apparatus 50 (step S19). As a result, the second recipe RP2 stored in the second storage 53 of the second processing apparatus 50 is modified (overwritten) into (with) the second recipe RP2 transmitted from the integrated control device 10.

After having transmitted the first and second recipes RP1 and RP2, the controller 13 ends the integrated-recipe editing processing shown in Fig. 6.

Next, processing that is executed by the controller 13 of the integrated control device 10 to control the second container transport mechanism 92, and processing that is executed by the first controller 24 of the batch processing apparatus 20 to control the first container transport mechanism 32 are described with reference to Figs. 1, 3, 7, and 8.

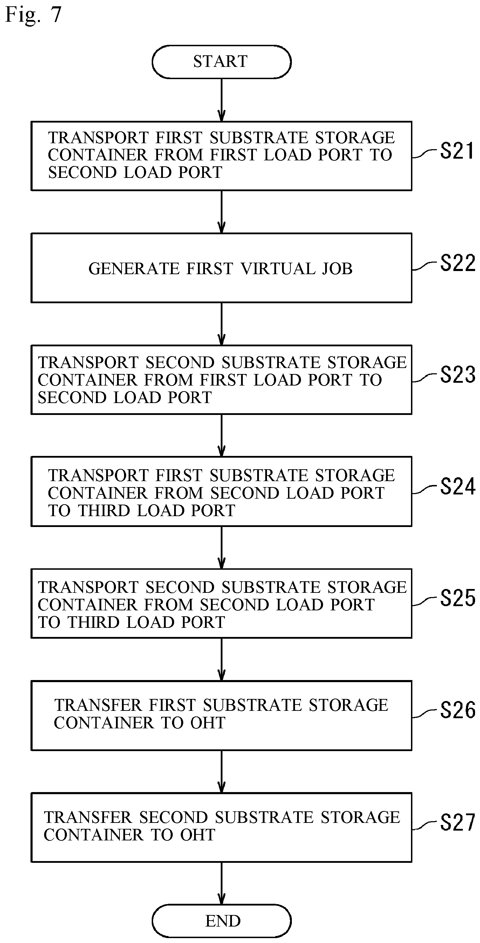

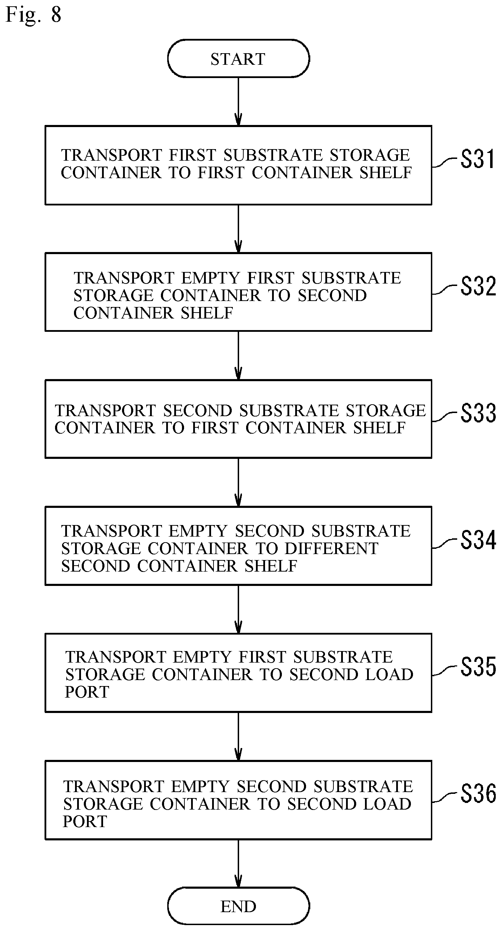

Fig. 7 is a flowchart showing a procedure of processing executed by the controller 13 of the integrated control device 10 included in the substrate processing system 1000 according to the present embodiment. For example, the processing shown in Fig. 7 may be started in response to the integrated control device 10 (communicator 11) having received a command to create an integrated job from the host computer HC. Fig. 8 is a flowchart showing a procedure of processing executed by the first controller 24 of the batch processing apparatus 20 included in the substrate processing system 1000 according to the present embodiment. The processing shown in Fig. 8 is started in response to the batch processing apparatus 20 having received a first virtual job.

As shown in Fig. 7, when a command to create an integrated job is received from the host computer HC via the communicator 11, the controller 13 of the integrated control device 10 controls the second container transport mechanism 92 to transport the first substrate storage container CA1 placed on the first load port LP1 to the second load port LP2 and place the first substrate storage container CA1 on the second load port LP2 (step S21). Note that the first substrate storage container CA1 is placed on the first load port LP1 by an OHT. When the first substrate storage container CA1 is transported from the first load port LP1 to the second load port LP2, the second substrate storage container CA2 is placed on the first load port LP1 by the OHT.

When a command to create an integrated job is received from the host computer HC via the communicator 11, the controller 13 generates a first virtual job with reference to the integrated recipe information HR (step S22). Then, the controller 13 transmits the first virtual job to the batch processing apparatus 20. The first virtual job includes information for identifying the first recipe RP1 integrated into the integrated recipe. The first controller 24 of the batch processing apparatus 20 controls the operation of each constituent element of the batch processing apparatus 20 with reference to the first recipe RP1 designated by the first virtual job.

To be more specific, the command to create an integrated job includes information for identifying the integrated recipe. The information for identifying the integrated recipe may indicate, for example, the name set for the integrated recipe. The controller 13 generates the first virtual job with reference to the information for identifying the integrated recipe and the information for identifying the first recipe RP1, which are included in the integrated recipe information HR. The information for identifying the first recipe RP1 may indicate, for example, the name set for the first recipe RP1.

As shown in Fig. 8, when the first virtual job is received via the first communicator 22, the first controller 24 of the batch processing apparatus 20 controls the first container transport mechanism 32 to transport the first substrate storage container CA1 placed on the second load port LP2 to the first container shelf 33a and place the first substrate storage container CA1 on the first container shelf 33a (step S31). Then, the first controller 24 controls the first lot transport mechanism HTR to transport the first lot contained in the first substrate storage container CA1 placed on the first container shelf 33a to the first orientation conversion mechanism CTC.

When the first lot is transported from the first substrate storage container CA1, the first controller 24 controls the first container transport mechanism 32 to transmit the empty first substrate storage container CA1 placed on the first container shelf 33a to one of the second container shelves 33b and place the empty first substrate storage container CA1 on the one second container shelf 33b (step S32).

As shown in Fig. 7, when the first substrate storage container CA1 is transported from the second load port LP2 to the first container shelf 33a, the controller 13 of the integrated control device 10 controls the second container transport mechanism 92 to transport the second substrate storage container CA2 placed on the first load port LP1 to the second load port LP2 and place the second substrate storage container CA2 on the second load port LP2 (step S23).

As shown in Fig. 8, when the second substrate storage container CA2 is placed on the second load port LP2, the first controller 24 of the batch processing apparatus 20 controls the first container transport mechanism 32 to transport the second substrate storage container CA2 placed on the second load port LP2 to the first container shelf 33a and place the second substrate storage container CA2 on the first container shelf 33a (step S33). Then, the first controller 24 controls the first lot transport mechanism HTR to transport the second lot contained in the second substrate storage container CA2 placed on the first container shelf 33a to the first orientation conversion mechanism CTC.

When the second lot is transported out from the second substrate storage container CA2, the first controller 24 controls the first container transport mechanism 32 to transport the empty second substrate storage container CA2 placed on the first container shelf 33a to another one of the second container shelves 33b and place the empty second substrate storage container CA2 on the other one second container shelf 33b (step S34).

After the empty second substrate storage container CA2 is placed on the other one second container shelf 33b, the first controller 24 controls the first container transport mechanism 32 to transport the empty first substrate storage container CA1 from the second container shelf 33b to the second load port LP2 and place the empty first substrate storage container CA1 on the second load port LP2 (step S35).

As shown in Fig. 7, when the empty first substrate storage container CA1 is placed on the second load port LP2, the controller 13 of the integrated control device 10 controls the second container transport mechanism 92 to transport the empty first substrate storage container CA1 from the second load port LP2 to one of the third load ports LP3 and place the empty first substrate storage container CA1 on the one third load port LP3 (step S24).

As shown in Fig. 8, when the empty first substrate storage container CA1 is transported from the second load port LP2, the first controller 24 of the batch processing apparatus 20 controls the first container transport mechanism 32 to transport the empty second substrate storage container CA2 from the second container shelf 33b to the second load port LP2 and place the empty second substrate storage container CA2 on the second load port LP2 (step S36). As a result, the processing shown in Fig. 8 ends.

As shown in Fig. 7, when the empty second substrate storage container CA2 is placed on the second load port LP2, the controller 13 of the integrated control device 10 controls the second container transport mechanism 92 to transport the empty second substrate storage container CA2 from the second load port LP2 to another one of the third load ports LP3 and place the empty second substrate storage container CA2 on the other one third load port LP3 (step S25).

The first substrate storage container CA1 placed on the third load port LP3 receives the first lot that is returned after the dry processing executed by the second processing apparatus 50. As shown in Fig. 7, when the first lot is returned to the first substrate storage container CA1 placed on the third load port LP3, the controller 13 of the integrated control device 10 controls the second container transport mechanism 92 to transport the first substrate storage container CA1 to a transfer position at which substrate storage containers CA are transferred between the second container transport mechanism 92 and the OHT. As a result, the first substrate storage container CA1 is transferred from the second container transport mechanism 92 to the OHT (step S26).

Similarly, the second substrate storage container CA2 placed on the third load port LP3 receives the second lot that is returned after the dry processing executed by the second processing apparatus 50. When the second lot is returned to the second substrate storage container CA2 placed on the third load port LP3, the controller 13 controls the second container transport mechanism 92 to transport the second substrate storage container CA2 to a transfer position at which substrate storage containers CA are transferred between the second container transport mechanism 92 and the OHT. As a result, the second substrate storage container CA2 is transferred from the second container transport mechanism 92 to the OHT (step S27). After the second substrate storage container CA2 is transferred from the second container transport mechanism 92 to the OHT, the processing shown in Fig. 7 ends.

Note that each processing of steps S24 and S25 shown in Fig. 7 and steps S35 and S36 shown in Fig. 8 may be executed before the substrates W are transported into a substrate storage container CA by the indexer robot IR of the sheet-fed processing apparatus 50. For example, the first substrate storage container CA1 may be transported to the third load port LP3 with the same timing when the first substrate W in the first lot is transported from the batch processing apparatus 20 to the sheet-fed processing apparatus 50. Similarly, the second substrate storage container CA2 may be transported to the third load port LP3 with the same timing when the first substrate W in the second lot is transported from the batch processing apparatus 20 to the sheet-fed processing apparatus 50.

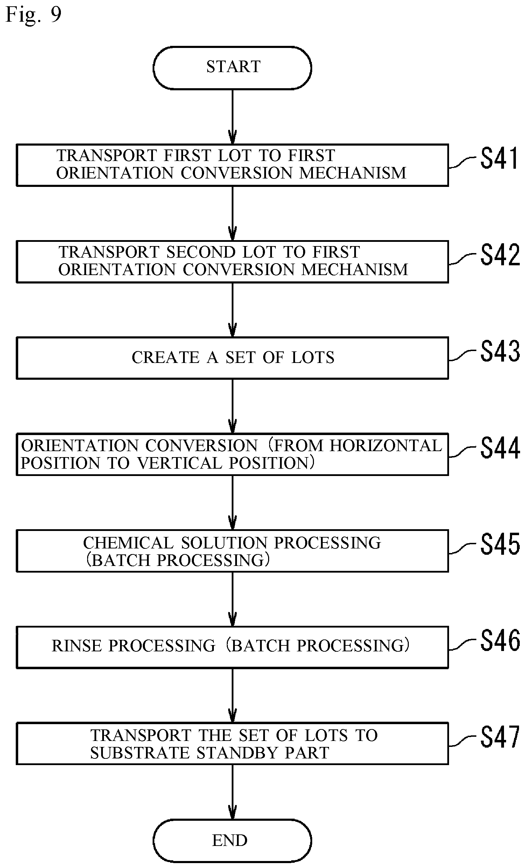

Next, the processing executed by the first controller 24 of the batch processing apparatus 20 in accordance with the first virtual job is described with reference to Figs. 1, 3, and 9. Fig. 9 is a flowchart showing a procedure of the processing executed by the first controller 24 of the batch processing apparatus 20 in accordance with the first virtual job. To be more specific, Fig. 9 shows a procedure of processing in which the first controller 24 of the batch processing apparatus 20 controls the first lot transport mechanism HTR, the first orientation conversion mechanism CTC, the second lot transport mechanism WTR, and the first to sixth batch processing units BPU1 to BPU6 in accordance with the first virtual job. The processing shown in Fig. 9 is started when the first container transport mechanism 32 places the first substrate storage container CA1 on the first container shelf 33a.

As shown in Fig. 9, when the first substrate storage container CA1 is placed on the first container shelf 33a (step S31 in Fig. 8), the first controller 24 controls the first lot transport mechanism HTR to transport the first lot contained in the first substrate storage container CA1 placed on the first container shelf 33a to the first orientation conversion mechanism CTC (step S41).

When the second substrate storage container CA2 is placed on the first container shelf 33a after the first lot is transported to the first orientation conversion mechanism CTC (step S33 in Fig. 8), the first controller 24 controls the first lot transport mechanism HTR to transport the second lot contained in the second substrate storage container CA2 placed on the first container shelf 33a to the first orientation conversion mechanism CTC (step S42).

The first controller 24 controls the first orientation conversion mechanism CTC to create a set of lots (step S43).

When a set of lots is created, the first controller 24 controls the first orientation conversion mechanism CTC to convert the orientation of each substrate W of the set of lots from a horizontal position to a vertical position (step S44). As a result, the orientation of the set of lots is converted from a horizontal position to a vertical position.

After the orientation of the set of lots is converted, the first controller 24 controls the second lot transport mechanism WTR to transport the set of lots to one of the first to fourth batch processing units BPU1 to BPU4. As a result, the chemical solution processing is executed on the set of lots inside the one of the first to fourth batch processing units BPU1 to BPU4 (step S45).

Specifically, the first controller 24 controls the second lot transport mechanism WTR to place the set of lots on the support member 35 of one of the first to fourth lifters LF1 to LF4. Thereafter, the lifter that supports the set of lots is controlled to move down from the upper position to the lower position. As a result, the set of lots is immersed in the chemical solution stored in the corresponding chemical solution tank, and the chemical solution processing is executed on the set of lots.

When a predetermined period of time has elapsed since the start of the chemical solution processing, the first controller 24 controls the second lot transport mechanism WTR to transport the set of lots from one of the first to fourth batch processing units BPU1 to BPU4 to one of the fifth and sixth batch processing units BPU5 and BPU6. As a result, the rinse processing is executed on the set of lots inside the one of the fifth and sixth batch processing units BPU5 and BPU6 (step S46).

Specifically, when a predetermined period of time has elapsed since the start of the chemical solution processing, the first controller 24 controls the lifter that supports the set of lots to move up from the lower position to the upper position. Then, the second lot transport mechanism WTR is controlled to grasp the set of lots supported by the lifter.

After the set of lots is grasped by the second lot transport mechanism WTR, the first controller 24 controls the second lot transport mechanism WTR to transport the set of lots. Then, the first controller 24 controls the second lot transport mechanism WTR to place the set of lots on the support member 35 of one of the fifth and sixth lifters LF5 and LF6. Thereafter, the lifter that supports the set of lots is controlled to move down from the upper position to the lower position. As a result, the set of lots is immersed in the rinsing liquid stored in the corresponding rinse tank, and the rinse processing is executed on the set of lots.

After a predetermined period of time has elapsed since the start of the rinse processing, the first controller 24 controls the second lot transport mechanism WTR to transport the set of lots from one of the fifth and sixth batch processing units BPU5 and BPU6 to the substrate standby part 40 (step S47). As a result, the processing shown in Fig. 9 ends.

Specifically, after a predetermined period of time has elapsed since the start of the rinse processing, the first controller 24 controls the lifter that supports the set of lots to move up from the lower position to the upper position. Then, the second lot transport mechanism WTR is controlled to grasp the set of lots supported by the lifter.

After the set of lots is grasped by the second lot transport mechanism WTR, the first controller 24 controls the second lot transport mechanism WTR to transport the set of lots. Then, the first controller 24 controls the second lot transport mechanism WTR to place the set of lots on the support member 35 of the seventh lifter LF7.

When the set of lots is supported by the seventh lifter LF7, the first controller 24 notifies the integrated control device 10 of the occurrence of a completed event of the first virtual job via the first communicator 22 as described with reference to Fig. 3.

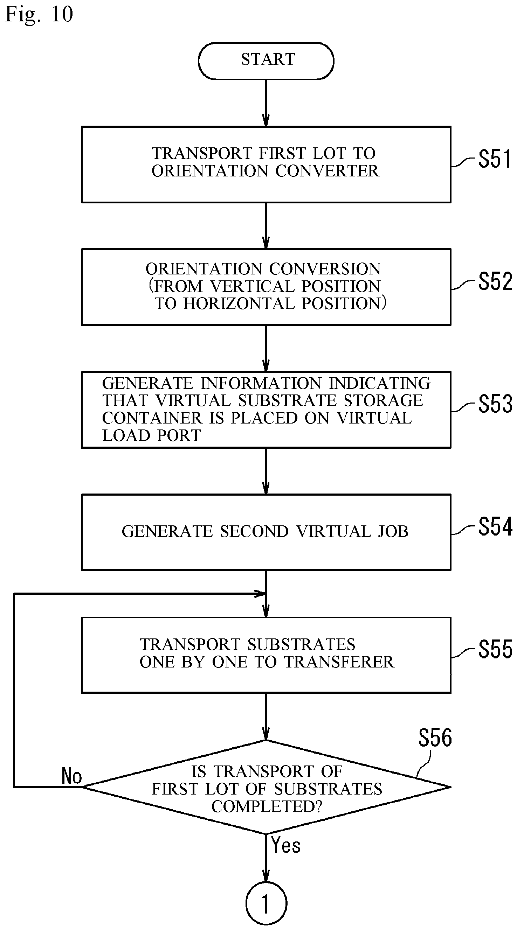

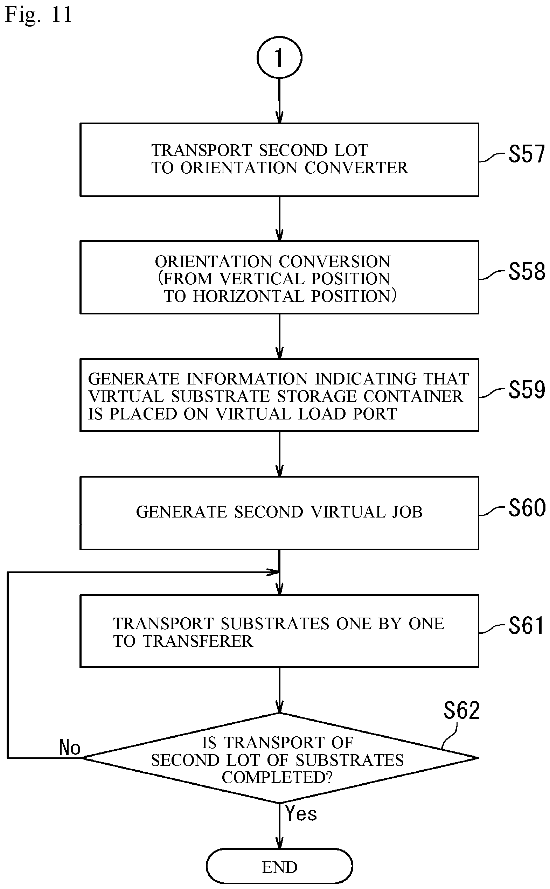

Next, the processing executed by the controller 13 of the integrated control device 10 is described with reference to Figs. 1, 3, 10, and 11. Figs. 10 and 11 are flowcharts showing a procedure of the processing executed by the controller 13 of the integrated control device 10 included in the substrate processing system 1000 according to the present embodiment. To be more specific, Figs. 10 and 11 show the procedures of processing in which the controller 13 of the integrated control device 10 controls the chuck mechanism TFC and the orientation converter 43. The processing shown in Figs. 10 and 11 is started in response to the batch processing apparatus 20 notifying the integrated control device 10 of the occurrence of a completed event of the first virtual job. That is, the processing shown in Figs. 10 and 11 is started in response to the set of lots being supported by the seventh lifter LF7.

When the processing shown in Figs. 10 and 11 is started, the controller 13 controls the chuck mechanism TFC to transport the first lot in the set of lots to the orientation converter 43 (step S51). To be more specific, the controller 13 firstly controls the seventh lifter LF7 to move down from the upper position to the lower position. As a result, the set of lots is immersed in the fluid stored in the standby tank 42. Thereafter, the controller 13 controls the chuck mechanism TFC so that the first lot is grasped by the pair of chucks 41. Then, the first controller 24 controls the chuck mechanism TFC to move the first lot to above the liquid level of the standby tank 42 and then transport the first lot to the orientation converter 43.

When the first lot is transported to the orientation converter 43, the controller 13 controls the second orientation conversion mechanism of the orientation converter 43 to convert the orientation of each substrate W of the first lot from a vertical position to a horizontal position (step S52). That is, the controller 13 controls the second orientation conversion mechanism to convert the orientation of the first lot from a vertical position to a horizontal position.

Moreover, after the orientation of the first lot is converted from a vertical position to a horizontal position, the controller 13 controls the second orientation conversion mechanism to adjust the position in the up-down direction of each substrate W in the first lot such that the uppermost substrate W in the first lot of substrates W is located above the liquid level of the immersion tank. As a result, the first lot enters a standby state in the substrate standby part 40. The controller 13 of the integrated control device 10 generates a second virtual job in response to the first lot becoming on standby in the substrate standby part 40. In this way, according to Embodiment 1, in the case of generating the second virtual job (control job), each substrate W in the first lot is on standby in the substrate standby part 40. Accordingly, the sheet-fed processing apparatus 50 is capable of processing the substrates W in the first lot one by one by executing the second virtual job (control job).

To be more specific, in response to the first lot becoming on standby in the substrate standby part 40, the controller 13 generates information indicating that a virtual substrate storage container is placed on a virtual load port (step S53). Hereinafter, the information indicating that a virtual substrate storage container is placed on a virtual load port may also be referred to as the "virtual placement information." After the virtual placement information is generated, the controller 13 transmits the virtual placement information and information for identifying the virtual load port to the sheet-fed processing apparatus 50 via the communicator 11. The virtual load port is one example of a "virtual container placement part."

When the virtual placement information is transmitted to the second processing apparatus 50, the controller 13 generates a second virtual job with reference to the integrated recipe information HR (step S54). Then, the controller 13 transmits the second virtual job to the sheet-fed processing apparatus 50. The second virtual job includes information for identifying the second recipe RP2 integrated into the integrated recipe. To be more specific, the controller 13 generates the second virtual job with reference to the information for identifying the second recipe RP2 included in the integrated recipe information HR. For example, the information for identifying the second recipe RP2 may indicate the name set for the second recipe RP2.

The second controller 54 of the sheet-fed processing apparatus 50 controls the operation of each constituent element of the sheet-fed processing apparatus 50 with reference to the second recipe RP2 designated by the second virtual job. To be more specific, the second storage 53 of the sheet-fed processing apparatus 50 stores the information for identifying the virtual load port together with the information for identifying the third load port LP3. When the virtual placement information and the information for identifying the virtual load port, transmitted from the integrated control device 10, are received via the second communicator 52, the second controller 54 becomes capable of executing the second virtual job as in the case where the substrate storage container CA is placed on one of the third load ports LP3. Accordingly, even if substrates Ware directly transported from the batch processing apparatus 20 to the sheet-fed processing apparatus 50, the sheet-fed processing apparatus 50 is capable of processing the substrates W transported from the batch processing apparatus 20 in accordance with the second recipe RP2.

When the second virtual job is transmitted to the sheet-fed processing apparatus 50, the controller 13 controls the substrate transport mechanism 82 to transport the substrates W in the first lot one by one from the substrate standby part 40 to the transferer 62 (step S55). Specifically, the substrate transport mechanism 82 grasps the uppermost substrate W in the first lot, located above the liquid level of the immersion tank, and transports this substrate W to the transferer 62. When the substrate W is transported to the transferer 62 by the substrate transport mechanism 82, the controller 13 controls the transferer 62 to hold the substrate W. Every time the substrate transport mechanism 82 transports a substrate W, the controller 13 controls the second orientation conversion mechanism to adjust the position in the up-down direction of each substrate W in the first lot such that the uppermost substrate W in the first lot of substrates W is located above the liquid level of the immersion tank.

Every time the substrate transport mechanism 82 transports a substrate W, the controller 13 determines whether the transport of the first lot of substrates W is completed (step S56). The controller 13 causes the substrate transport mechanism 82 to transport a substrate W until the transport of the first lot of substrates W is completed (No in step S56).

When it is determined that the transport of the first lot of substrates W is completed (Yes in step S56), as shown in Fig. 11, the controller 13 controls the chuck mechanism TFC to transport the second lot in the set of lots to the orientation converter 43 (step S57). Each processing of steps S57 to S62 is approximately the same as the processing of steps S51 to S56, and therefore descriptions thereof shall be omitted. The processing shown in Figs. 10 and 11 is ended by the controller 13 when it is determined that the transport of the second lot of substrates W is completed (Yes in step S62).

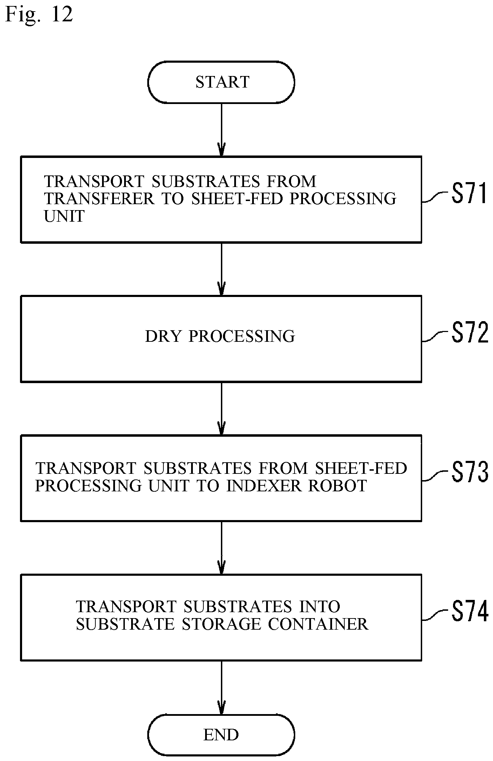

Next, the processing executed by the second controller 54 of the sheet-fed processing apparatus 50 in accordance with the second virtual job is described with reference to Figs. 1, 3, 4, and 12. Fig. 12 is a flowchart showing a procedure of the processing executed by the second controller 54 of the sheet-fed processing apparatus 50 in accordance with the second virtual job. To be more specific, Fig. 12 shows a procedure of processing in which the sheet-fed processing apparatus 50 executes the dry processing on one substrate W included in the first lot.

The processing shown in Fig. 12 is started in response to a substrate W being held by the transferer 62. To be more specific, in response to a substrate W being held by the transferer 62, the controller 13 of the integrated control device 10 notifies the sheet-fed processing apparatus 50 of the completion of processing executed inside the chamber 63a. When the notification indicating the completion of processing performed in the chamber 63a is received via the second communicator 52, the second controller 54 of the sheet-fed processing apparatus 50 starts the processing shown in Fig. 12.

When the processing shown in Fig. 12 is started, the second controller 54 controls the center robot CR to transport substrates W (substrates W that have undergone the rinse processing) from the transferer 62 to one of the sheet-fed processing units 63 (step S71). Then, the second controller 54 causes the sheet-fed processing unit 63 to execute the dry processing (step S72).

Specifically, the second controller 54 controls the spin chuck 64 to hold the substrate W transported into the chamber 63b by the center robot CR. Then, the second controller 54 controls the spin chuck 64 to rotate the substrate W. When the rotational speed of the substrate W has reached a predetermined rotational speed, the second controller 54 opens the on-off valve 72. As a result, IPAis ejected from the nozzle 65 toward the rotating substrate W, and a liquid membrane of IPA is formed on the upper surface of the substrate W.

When a predetermined period of time has elapsed since the start of IPA ejection, the second controller 54 closes the on-off valve 72. As a result, the ejection of IPA from the nozzle 65 is stopped. When the ejection of IPA is stopped, the second controller 54 controls the spin chuck 64 to increase the rotational speed of the substrate W. As a result, IPA is scattered from the substrate W, and the substrate W is dried. When a predetermined period of time has elapsed since the increase in the rotational speed of the substrate W, the second controller 54 controls the spin chuck 64 to stop the rotation of the substrate W. As a result, the dry processing ends.

When the dry processing ends, the second controller 54 controls the center robot CR and the indexer robot IR to transport the substrates W from the sheet-fed processing unit 63 to the indexer robot IR (step S73).

When the substrates Ware transferred from the center robot CR to the indexer robot IR, the second controller 54 controls the indexer robot IR to transport the substrates W into the first substrate storage container CA1 placed on one of the third load ports LP3 (step S74). As a result, the substrates W that have undergone the dry processing are contained in the first substrate storage container CA1, and the processing shown in Fig. 12 ends.

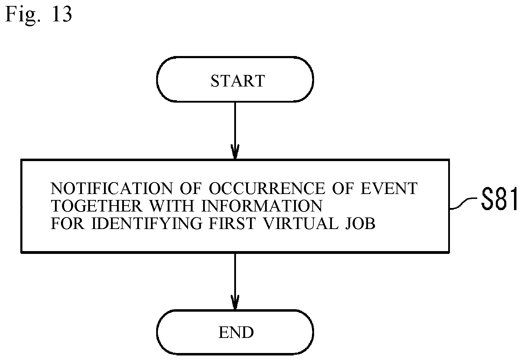

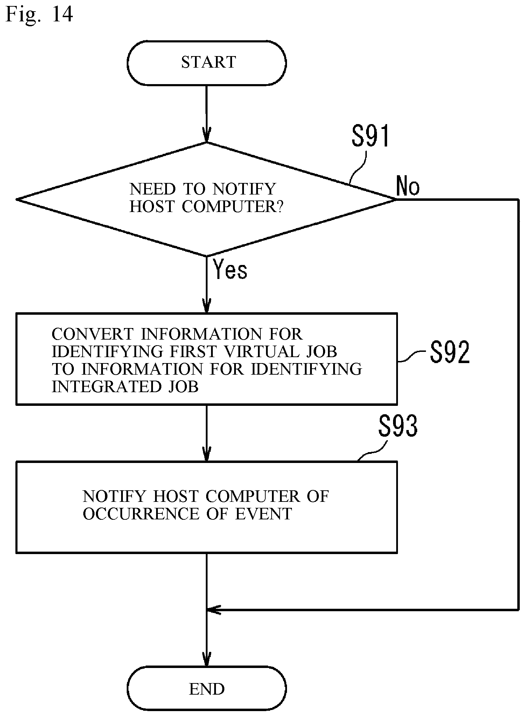

Next, processing for issuing a notification indicating the occurrence of an event is described with reference to Figs. 1, 13, and 14. Fig. 13 is a flowchart showing a procedure of notification processing executed by the first controller 24 of the first processing apparatus 20 when an event has occurred in the first processing apparatus 20 operating based on the first virtual job. Fig. 14 is a flowchart showing a procedure of notification processing executed by the controller 13 of the integrated control device 10 when an event has occurred in the first processing apparatus 20 operating based on the first virtual job.

As shown in Fig. 13, when an event has occurred while each consistent element of the first processing apparatus 20 is controlled based on the first virtual job, the first controller 24 of the first processing apparatus 20 notifies the integrated control device 10 of the event that occurred in the first processing apparatus 20, together with the information for identifying the first virtual job, via the first communicator 22 (step S81). As a result, the processing shown in Fig. 13 ends.

As shown in Fig. 14, when a notification indicating the occurrence of the event is received from the first processing apparatus 20, the controller 13 of the integrated control device 10 determines whether to notify the host computer HC of the event that has occurred in the first processing apparatus 20 (step S91).

When the controller 13 has determined not to notify the host computer HC of the occurrence of the event (No in step S91), the processing shown in Fig. 14 ends. For example, events that occur in the first processing apparatus 20 may include a completed event that indicates completion of the processing based on the first virtual job. In the case where the event notified from the first processing apparatus 20 is a completed event of the first virtual job, the controller 13 determines not to notify the host computer HC of the completed event.

On the other hand, when the controller 13 has determined to notify the host computer HC of the occurrence of the event (Yes in step S91), the controller 13 converts the information for identifying the first virtual job into information for identifying the integrated job (step S92) and notifies the host computer HC of the event that has occurred in the first processing apparatus 20, together with the information for identifying the integrated job (step S93). As a result, the processing shown in Fig. 14 ends.

Note that the notification processing to be executed when an event has occurred in the second processing apparatus 50 operating based on the second virtual job is approximately the same as the processing described with reference to Figs. 13 and 14, except for processing for notifying the completed event, and therefore a description thereof shall be omitted.

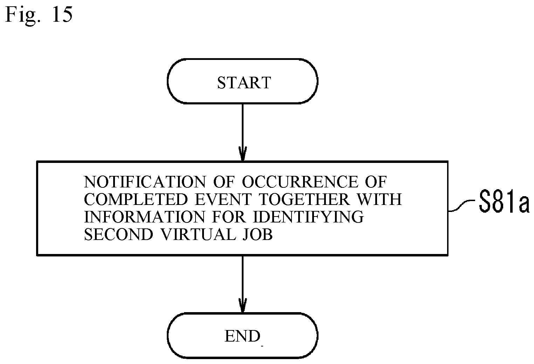

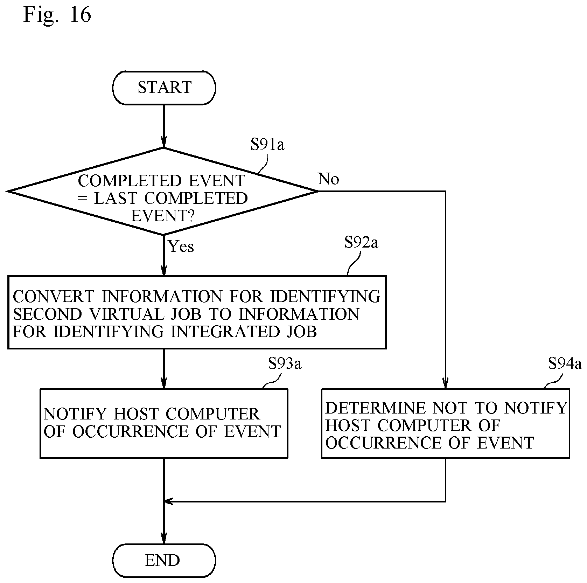

Next, the processing for notifying the host computer HC of the occurrence of a completed event is described with reference to Figs. 1, 15, and 16. Fig. 15 is a flowchart showing a procedure of notification processing executed by the second controller 54 of the second processing apparatus 50 when a completed event has occurred in the second processing apparatus 50 operating based on the second virtual job. Fig. 16 is a flowchart showing a procedure of notification processing executed by the controller 13 of the integrated control device 10 when a completed event has occurred in the second processing apparatus 50 operating based on the second virtual job.

As shown in Fig. 15, when a completed event has occurred while each constituent element of the second processing apparatus 50 is controlled based on the second virtual job, the second controller 54 of the second processing apparatus 50 notifies the integrated control device 10 of the completed event that has occurred in the second processing apparatus 50, together with the information for identifying the second virtual job, via the second communicator 52 (step S81a). As a result, the processing shown in Fig. 15 ends.

To be more specific, as described with reference to Fig. 2 and so on, the integrated control device 10 generates a second virtual job multiple times. Thus, events that occur in the second processing apparatus 50 include a plurality of completed events that indicate completion of processing based on each of the second virtual jobs. Then, the completed events include a last completed event that is a completed event notified at last by the second processing apparatus 50. In the present embodiment, the integrated control device 10 generates a second virtual job twice. Thus, the completed event notified for the second time from the second processing apparatus 50 to the integrated control device 10 corresponds to the last completed event.

As shown in Fig. 16, when the second processing apparatus 50 has notified the communicator 11 of the occurrence of a completed event, the controller 13 of the integrated control device 10 determines whether the completed event is the last completed event (step S91a).

When it is determined that the completed event notified from the second processing apparatus 50 is not the last completed event (No in step S91a), the controller 13 determines not to notify the host computer HC of the occurrence of the event (step S94a), and ends the processing shown in Fig. 16.

On the other hand, when it is determined that the completed event notified from the second processing apparatus 50 is the last completed event (Yes in step S91a), the controller 13 converts the information for identifying the second virtual job into information for identifying the integrated job (step S92a) and notifies the host computer HC of the completed event together with the information for identifying the integrated job (step S93a). As a result, the processing shown in Fig. 16 ends.

As described above with reference to Figs. 1 to 16, according to Embodiment 1, the host computer HC may command the integrated control device 10 to create one job. Thus, the host computer HC does not need to command each of the first processing apparatus 20 and the second processing apparatus 50 to create a job. This eliminates the need to introduce a new system (software) into an existing host computer and suppresses an increase in the load on the operator who operates the host computer HC. Since the integrated control device 10 generates the first virtual job and the second virtual job in accordance with the command received from the host computer HC, the first processing apparatus 20 and the second processing apparatus 50 execute a series of substrate processing in cooperation with each other. This is compliant with SEMI standards because the first processing apparatus 20 and the second processing apparatus 50 do not execute the substrate processing in accordance with one job.

Moreover, according to Embodiment 1, the batch processing apparatus 20 can be used to execute the chemical solution processing and the rinse processing on a plurality of substrates W by one operation. This improves productivity and also reduces the amount of the chemical solution consumed.

According to Embodiment 1, the sheet-fed processing apparatus 50 can dry substrates W through the dry processing. The dry processing executed by the sheet-fed processing apparatus 50 is less likely to break pattens than the dry processing executed by the batch processing apparatus 20. Thus, patterns are less likely to be broken during the dry processing than in the case where the batch processing apparatus 20 executes the dry processing.

According to Embodiment 1, an existing recipe file can be used as a result of editing. This reduces the load on the operator as compared with the case of creating a new recipe file.

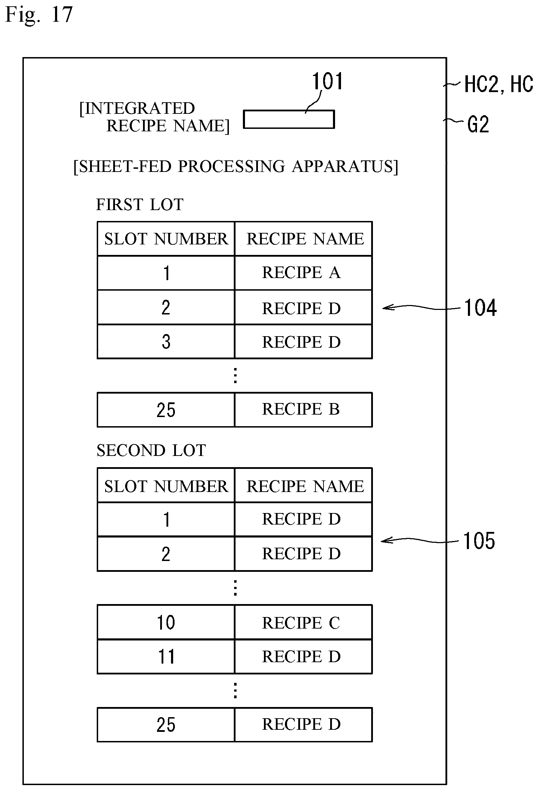

Next, a variation of the substrate processing system 1000 according to the present embodiment is described with reference to Figs. 1, 3, 17, and 18. Fig. 17 is a diagram showing one example of the second recipe editing screen G2. In the example shown in Fig. 17, the first recipe list field 102 shown in Fig. 5 is not shown in order to facilitate understanding.

As shown in Fig. 17, the second recipe editing screen G2 displays two recipe setting fields 104 and 105, instead of the second recipe list field 103 shown in Fig. 5. The recipe setting field 104 is an input field for setting a recipe (second recipe RP2) for each substrate W of the first lot. The recipe setting field 105 is an input field for setting a recipe (second recipe RP2) for each substrate W of the second lot. The operator is able to set a different second recipe RP2 for each substrate W by operating the input device HC1 while the second recipe editing screen G2 is displayed. In response to the operator having set the second recipe RP2 for each substrate W via the second recipe editing screen G2, the controller 13 of the integrated control device 10 integrates the second recipe RP2 into an integrated recipe in units of one substrate at the time of editing the integrated recipe.

In the example shown in Fig. 17, a recipe A is set for the first substrate W (slot number 1) of the first lot, a recipe D is set for the 2nd to 24th substrates W (slot numbers 2 to 24) of the first lot, and a recipe B is set for the 25th substrate W (slot number 25) of the first lot. In the example shown in Fig. 17 the recipe D is set for the first to ninth substrates W (slot numbers 1 to 9) of the second lot, a recipe C is set for the tenth substrate W ( slot number 10) of the second lot, and the recipe D is set for the 11th to 25th substrates W (slot numbers 11 to 25) of the second lot.

Note that the recipes A to D are different second recipes RP2. The recipes A to D may be existing recipe files stored in the second storage 53 of the sheet-fed processing apparatus 50, or may be recipe files newly created by the operator.

Newly created recipe files are stored in the second storage 53 of the sheet-fed processing apparatus 50 at the time of editing the integrated recipe. In the case of using existing recipe files, the operator edits the existing recipes A to D via the second individual recipe editing screen as described with reference to Fig. 5. As described with reference to Fig. 6, the existing recipes A to D stored in the second storage 53 are modified into recipes A to D that are edited via the second individual recipe editing screen.

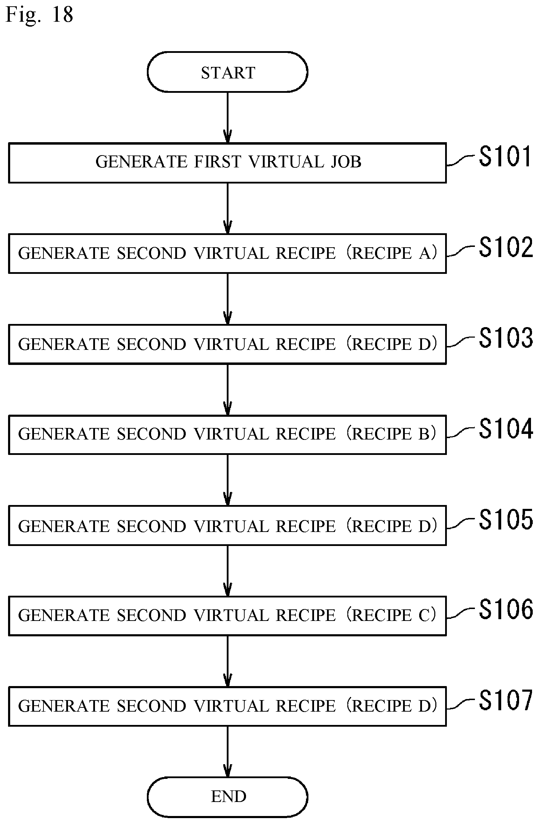

Next, the processing executed by the controller 13 of the integrated control device 10 is described with reference to Figs. 1, 17, and 18. Fig. 18 is a flowchart showing a procedure of the processing executed by the controller 13 of the integrated control device 10 included in the variation of the substrate processing system 1000 according to the present embodiment. The processing shown in Fig. 18 is started when the integrated control device 10 has received a command to create an integrated job from the host computer HC.

When the processing shown in Fig. 18 is started, the controller 13 generates a first virtual job with reference to the integrated recipe information HR and transmits the first virtual job from the communicator 11 to the first processing apparatus 20 as in step S1 shown in Fig. 2 (step S101). As a result, the first processing apparatus 20 executes the chemical solution processing and the rinse processing on a set of lots by one operation.

After the execution of the chemical solution processing and the rinse processing on the set of lots is completed, the controller 13 generates a second virtual job with reference to the integrated recipe information HR and transmits the second virtual job from the communicator 11 to the second processing apparatus 50 (steps S102 to S107). To be more specific, in the case where two or more second recipes RP2 are integrated into an integrated recipe, the controller 13 generates two or more second virtual jobs.

For example, in the case where the second recipes RP2 are set as shown in Fig. 17 and when the substrate transport mechanism 82 transports the first substate W of the first lot, the controller 13 generates a second virtual job that indicates information for identifying the recipe A and transmits the second virtual job to the second processing apparatus 50 (step S102).

When the substrate transport mechanism 82 transports the second substrate W of the first lot, the controller 13 generates a second virtual job that indicates information for identifying the recipe D and transmits the second virtual job to the second processing apparatus 50 (step S103).

When the substrate transport mechanism 82 transports the 25th substrate W of the first lot, the controller 13 generates a second virtual job that indicates information for identifying the recipe B and transmits the second virtual job to the second processing apparatus 50 (step S104).

Note that, every time the substrate transport mechanism 82 transports each of the 2nd to 24th substrates W of the first lot, the controller 13 may transmit the second virtual job indicating the information for identifying the recipe D to the second processing apparatus 50.

When the substrate transport mechanism 82 transports the first substrate W of the second lot, the controller 13 generates a second virtual job that indicates information for identifying the recipe D and transmits the second virtual job to the second processing apparatus 50 (step S105). As described with reference to Fig. 2, the controller 13 transmits a second virtual job when the lots are switched to one to another. Accordingly, even in the case where the recipe that is set for the 25th substrate W of the first lot is the same as the recipe that is set for the first substrate W of the second lot, the controller 13 transmits a second virtual job when the substrate transport mechanism 82 transports the first substrate W of the second lot.

When the substrate transport mechanism 28 transports the tenth substrate W of the second lot, the controller 13 generates a second virtual job that indicates information for identifying the recipe C and transmits the second virtual job to the second processing apparatus 50 (step S106).

Note that, every time the substrate transport mechanism 82 transports each of the first to ninth substrates W of the second lot, the controller 13 may transmit a second virtual job indicating the information for identifying the recipe D to the second processing apparatus 50.

When the substrate transport mechanism 82 transports the eleventh substrate W of the second lot, the controller 13 generates a second virtual job that indicates information for identifying the recipe D and transmits the second virtual job to the second processing apparatus 50 (step S107). As a result, the processing shown in Fig. 18 ends.

Note that, every time the substrate transport mechanism 82 transports each of the 11th to 25th substrates W, the controller 13 may transmit a second virtual job that indicates information for identifying the recipe D to the second processing apparatus 50.

As described above with reference to Figs. 1, 3, 17, and 18, a recipe can be modified in units of one substrate according to Embodiment 1. Thus, it is possible to change the processing to be executed by the sheet-fed processing apparatus 50 for each substrate W. While the recipe for the second processing apparatus 50 is set for each substrate W in the example described with reference to Figs. 1, 3, 17, and 18, the recipe for the first processing apparatus 20 may be set for each substrate W if the first processing apparatus 20 is a sheet-fed processing apparatus.

### Embodiment 2

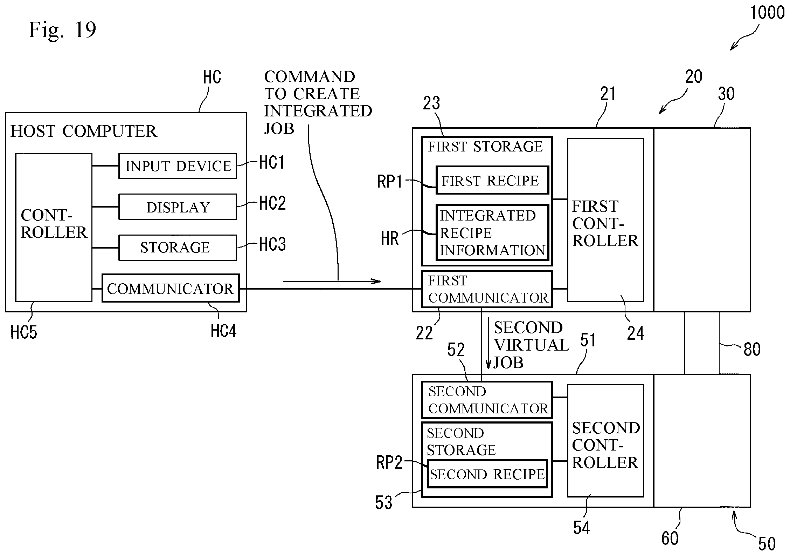

Next, Embodiment 2 according to the present invention is described with reference to Fig. 19. Note that matters that are different from those of Embodiment 1 are described below, and descriptions of matters that are identical to those of Embodiment 1 shall be omitted. Embodiment 2 is different from Embodiment 1 in that the first control device 21 of the first processing apparatus 20 serves also as the integrated control device 10 described with reference to Figs. 1 to 18.

Fig. 19 is a block diagram showing a configuration of a processing system 1000 according to the present embodiment. As shown in Fig. 19, the substrate processing system 1000 according to the present embodiment includes the first processing apparatus 20 and the second processing apparatus 50.

The first processing apparatus 20 executes the first processing on substrates W in accordance with one job as in Embodiment 1. The second processing apparatus 50 executes the second processing on substrates W in accordance with one job as in Embodiment 1.

In the present embodiment, the first communicator 22 of the first processing apparatus 20 establishes communication between the communicator HC4 of the host computer HC and the second communicator 52 of the second processing apparatus 50. As described previously, the first control device 21 of the first processing apparatus 20 according to the present embodiment serves also as the integrated control device 10. Thus, the first controller 24 of the first control device 21 generates a first virtual job and a second virtual job in accordance with a command to create an integrated job, received from the host computer HC. The first controller 24 executes the first virtual job. The first controller 24 transmits the second virtual job to the second processing apparatus 50 via the first communicator 22 and causes the second processing apparatus 50 to execute the second virtual job.

Embodiment 2 according to the present invention has been described thus far with reference to Fig. 19. According to Embodiment 2, the host computer HC may command the integrated control device 10 to create one job as in Embodiment 1. Thus, it is possible to suppress an increase in the load on the operator who operates the host computer HC as in Embodiment 1.

Although the first control device 21 of the first processing apparatus 20 according to Embodiment 2 severs also as the integrated control device 10, the second control device 51 of the second processing apparatus 50 may serve also as the integrated control device 10.

### Embodiment 3

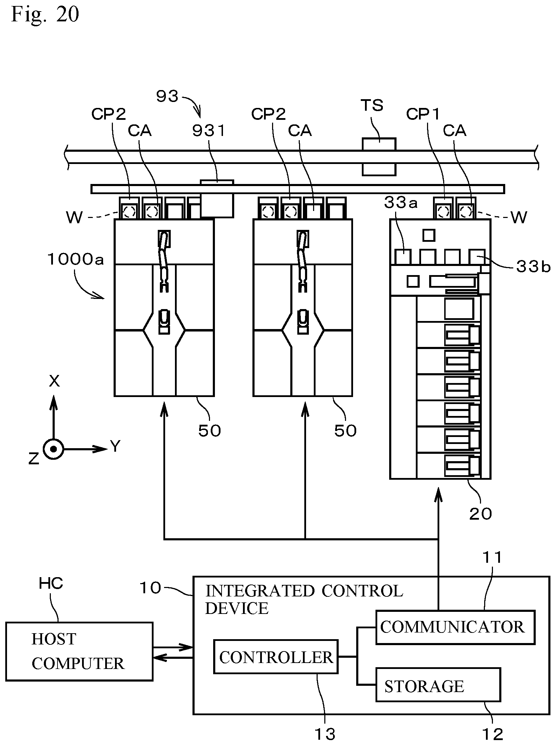

Fig. 20 is a block diagram showing a configuration of a substrate processing system 1000a according to Embodiment 3. As shown in Fig. 20, the substrate processing system 1000a is configured by omitting the first and second couplers 80 and 90 from the substrate processing system 1000 shown in Figs. 1 and 3 and omitting the substrate standby part 40 from the first processing apparatus 20. The substrate processing system 1000a further includes another second processing apparatus 50 and a local transport mechanism 93 in addition to the consistent elements of the substrate processing system 1000. The other configuration of the substrate processing system 1000a is approximately the same as that of the substrate processing system 1000 shown in Figs. 1 and 3.

In the substrate processing system 1000a, another second processing apparatus 50 is arranged adjacent to the -Y side of the second processing apparatus 50. These two second processing apparatuses 50 are processing apparatuses of the same type having approximately the same structure and each are configured to be capable of executing the second processing on substrates W in accordance with one job. In the present embodiment, the two second processing apparatuses 50 are sheet-fed processing apparatuses, and the first processing apparatus 20 is a batch processing apparatus as described above. Note that the substrate processing system 1000a may include three or more second processing apparatuses 50. That is, the substrate processing system 1000a includes a plurality of second processing apparatuses 50.

The local transport mechanism 93 is a mechanism for transporting substrate storage containers CA between the first processing apparatus 20 and the second processing apparatuses 50. The local transport mechanism 93 is a transport mechanism different from the aforementioned in-plant transport system TS that already exists in a clean room where the first processing apparatus 20 and the second processing apparatuses 50 are located. The local transport mechanism 93 may, for example, be an OHT or an automated guided vehicle (AGV) that operates independently of the in-plant transport system TS. The AGV is a transport mechanism that runs on the floor of the clean room.

The local transport mechanism 93 is configured to be capable of transferring substrate storage containers CA to and from the aforementioned in-plant transport system TS. The local transport mechanism 93 transports substrate storage containers CA only between the first processing apparatus 20 and the second processing apparatuses 50 and does not transport substrate storage containers CA between the substrate processing system 1000a and apparatuses other than the substrate processing system 1000a in the clean room, such as substrate processing apparatuses or container storage warehouses (i.e., carrier stockers that temporarily store substrate storage containers CA).

In the present embodiment, the local transport mechanism 93 is an OHT. For example, the local transport mechanism 93 may be arranged in the vicinity of an area located on the +X side of the first processing apparatus 20 and the second processing apparatuses 50. The local transport mechanism 93 is arranged above the first container placement parts CP1 of the first processing apparatus 20 and the second container placement parts CP2 of the second processing apparatuses 50 (i.e., on the +Z side). The local transport mechanism 93 includes a movable part 931 that holds and transports substrate storage containers CA. The movable part 931 is movable independently of the first processing apparatus 20 and the second processing apparatuses 50.

In the substrate processing system 1000a, the integrated control device 10 controls the first processing apparatus 20 and the second processing apparatuses 50 in accordance with a command received from the host computer HC. Specifically, the integrated control device 10 generates a first virtual job and a second virtual job in accordance with a command to create an integrated job, received from the host computer HC.

The integrated control device 10 transmits the first virtual job from the communicator 11 to the first processing apparatus 20 and causes the first processing apparatus 20 to execute the first virtual job. In the present embodiment, the first virtual job causes the first processing apparatus 20 (i.e., batch processing apparatus 20) to execute the chemical solution processing and the rinse processing. While the first processing apparatus 20 is executing the chemical solution processing and the rinse processing on substrates W, the two empty substrate storage containers CAthat have contained the substrates Ware placed on the first container shelf 33a and/or the second container shelves 33b.

The substrates W (i.e., the aforementioned first and second lots) that have undergone the processing executed by the first processing apparatus 20 are contained in the two substrate storage containers CA on the first container shelf 33a and/or the second container shelves 33b and placed on the first container placement parts CP1. The substrate storage containers CA that contain the substrates W processed by the first processing apparatus 20 may be substrate storage containers CA that had contained the substrates W before the execution of the processing by the first processing apparatus 20, or may be substrate storage containers CA that are different from those that had contained the substrates W. When the substrate storage containers CA containing the substrates W are placed on the first container placement parts CP1, the integrated control device 10 selects one of the second processing apparatuses 50.

For example, one second processing apparatus 50 may be selected as follows. Firstly, the integrated control device 10 issues a request to transmit queue information to each of the second processing apparatuses 50, and each second processing apparatus 50 transmits the queue information to the integrated control device 10. The queue information refers to information indicating the number of substrates W that queue for the processing to be executed by the second processing apparatus 50 (i.e., queue substrates W). The queue substrates W refer to substrates W that have already been transported to the second processing apparatuses 50 but have not yet been processed by the second processing apparatuses 50. The queue information about each second processing apparatus 50, transmitted from the second processing apparatus 50, is stored in the storage 12 of the integrated control device 10.

Then, the integrated control device 10 compares the queue information among the second processing apparatuses 50 and determines, based on the result of comparison, one second processing apparatus 50 into which the substrate storage containers CA transported from the first processing apparatus 20 are to be transported by the local transport mechanism 93. Specifically, for example, the integrated control device 10 may select one second processing apparatus 50 that includes a smallest number of queue substrates W from among the second processing apparatuses 50.

Then, the controller 13 of the integrated control device 10 controls the local transport mechanism 93 so that the substrate storage containers CA placed on the first container placement parts CP1 are held by the local transport mechanism 93, transported to second container placement parts CP2 of the selected one second processing apparatus 50, and placed on the second container placement parts CP2. In this way, the substrates W processed by the first processing apparatus 20 are transported into the one second processing apparatus 50. The local transport mechanism 93 transports the substrate storage containers CA transported out from the first processing apparatus 20, directly to the aforementioned one second processing apparatus 50 without passing through the aforementioned container warehouse or the like.

When the substrate storage containers CA are placed on the second container placement parts CP2 of the aforementioned one second processing apparatus 50, the integrated control device 10 transmits the second virtual job from the communicator 11 to the one second processing apparatus 50 and causes the one second processing apparatus 50 to execute the second virtual job. In the present embodiment, the second virtual job causes the one second processing apparatus 50 (i.e., sheet-fed processing apparatus 50) to execute the dry processing.

In this way, in the substrate processing system 1000a, the local transport mechanism 93 is capable of easily transporting substrate storage containers CA to one second processing apparatus 50, which is selected appropriately from among the second processing apparatuses 50. Since the substrate storage containers CA do not pass through any container warehouse or the like during transport from the first processing apparatus 20 to the one second processing apparatus 50, the time required for transport from a container warehouse or the like to the one second processing apparatus 50 does not increase due to factors such as a delay caused by transport of other substrate storage containers CA. Accordingly, it is possible to shorten the time from the end of the processing executed on the substrates W by the first processing apparatus 20 to the start of the processing executed on the substrates W by the one second processing apparatus 50.

In the substrate processing system 1000a, the aforementioned method of selecting one second processing apparatus 50 is not limited to the example described above. For example, the integrated control device 10 may issue a request to transmit maintenance information and the aforementioned queue information to each of the second processing apparatuses 50, and each second processing apparatus 50 transmits the maintenance information and the queue information to the integrated control device 10. The maintenance information refers to information indicating the estimated period of start of maintenance to be executed next in the second processing apparatus 50 (i.e., maintenance to be executed in the nearest future) and the estimated period of end of the maintenance. The maintenance information and the queue information about each second processing apparatus 50 transmitted from the second processing apparatus 50 are stored in the storage 12 of the integrated control device 10.

Then, the integrated control device 10 compares the queue information and the maintenance information among the second processing apparatuses 50 and determines, on the basis of the comparison result, one second processing apparatus 50 into which the substrate storage container CA transported out by the local transport mechanism 93 is to be transported from the first processing apparatus 20. Specifically, for example, one second processing apparatus 50 that is capable of, at the earliest time, processing substrates W contained in the substrate storage container CA estimated to be transported into the second processing apparatus 50 is selected from among the second processing apparatuses 50 in consideration of the number of queue substrates W and a schedule of maintenance.

For example, even in the case where any second processing apparatus 50 has a smallest number of queue substrates W among the second processing apparatuses 50, this second processing apparatus 50 may not be selected as the aforementioned one second processing apparatus 50 if its maintenance is scheduled to be carried out before the start of processing of substrates W in a substrate storage container CAthat is to be transported into the second processing apparatus 50 and if the processing of the substrates W in the substrate storage container CA delays in consideration of maintenance. Then, from among second processing apparatuses 50 whose maintenance are scheduled for some time later, the one with a smallest number of queue substrates W is selected as the aforementioned one second processing apparatus 50.

As described above, the substrate processing system 1000a includes the first processing apparatus 20, the second processing apparatuses 50, the integrated control device 10, and the local transport mechanism 93. The first processing apparatus 20 executes the first processing on substrates W in accordance with a job. The second processing apparatuses 50 each execute the second processing on substrates W in accordance with a job. The integrated control device 10 controls the first processing apparatus 20 and the second processing apparatuses 50 in accordance with a command received from an external control device (i.e., host computer HC). The local transport mechanism 93 is movable independently of the first processing apparatus 20 and the second processing apparatuses 50.

The job is a command to execute processing from transporting substrates W from a substrate storage container CA into a processing apparatus and executing processing on the substrates W inside the processing apparatus to transporting out the substrates W from the inside of the processing apparatus to the aforementioned substrate storage container CA or to another substrate storage container CA different from the aforementioned substrate storage container CA. The integrated control device 10 generates a first virtual job and a second virtual job in accordance with a command to create an integrated job, received from the host computer HC. The first processing apparatus 20 executes at least part of the first processing (in the aforementioned example, the chemical solution processing and the rinse processing) on the substrates W in accordance with the first virtual job. Among the second processing apparatuses 50, one second processing apparatus 50 selected by the integrated control device 10 executes, in accordance with the second virtual job, at least part of the second processing (in the aforementioned example, the dry processing) on the substrates W processed by the first processing apparatus 20.

The first processing apparatus 20 includes the first container placement part CP 1 on which a substrate storage container CA is placed. Each of the second processing apparatuses 50 includes the second container placement parts CP2 on which substrate storage containers CA are placed. The local transport mechanism 93 transports a substrate storage container CA that contains substates W processed by the first processing apparatus 20 from the first container placement part CP 1 to a second container placement part CP2 of the aforementioned one second processing apparatus 50 selected from among the second processing apparatuses 50.

Accordingly, it is possible to easily transport the substrate storage container CA to one second processing apparatus 50 selected properly from among the second processing apparatuses 50 as described above. Moreover, as described above, it is possible to shorten the time from the end of the processing executed on the substrates W by the first processing apparatus 20 to the start of the processing executed on the substrates W by the one second processing apparatus 50.

As described above, it is preferable that the first processing apparatus 20 may include a batch-type substrate processing apparatus capable of processing a plurality of substrates W by one operation, and the second processing apparatuses 50 each may include a sheet fed-type substrate processing apparatus that processes substrates one by one. Accordingly, it is possible to favorably achieve hybrid processing in which sheet-fed processing is executed on substrates W after batch processing is executed on the substrates W.

In the above-described example, the integrated control device 10 stores the queue information indicating the number of queue substrates W in each of the second processing apparatuses 50, and the maintenance information about each of the second processing apparatuses 50. Preferably, the integrated control device 10 may select one second processing apparatus 50 from among the second processing apparatuses 50 in accordance with the queue information and the maintenance information about each second processing apparatus 50. Accordingly, the aforementioned one second processing apparatus 50 can be selected in consideration of maintenance timing for each second processing apparatus 50. As a result, it is possible to select one second processing apparatus 50 that is capable of, at the earliest time, processing substrates W in a substrate storage container CAthat is scheduled to be transported into the processing apparatus.

### Embodiment 4

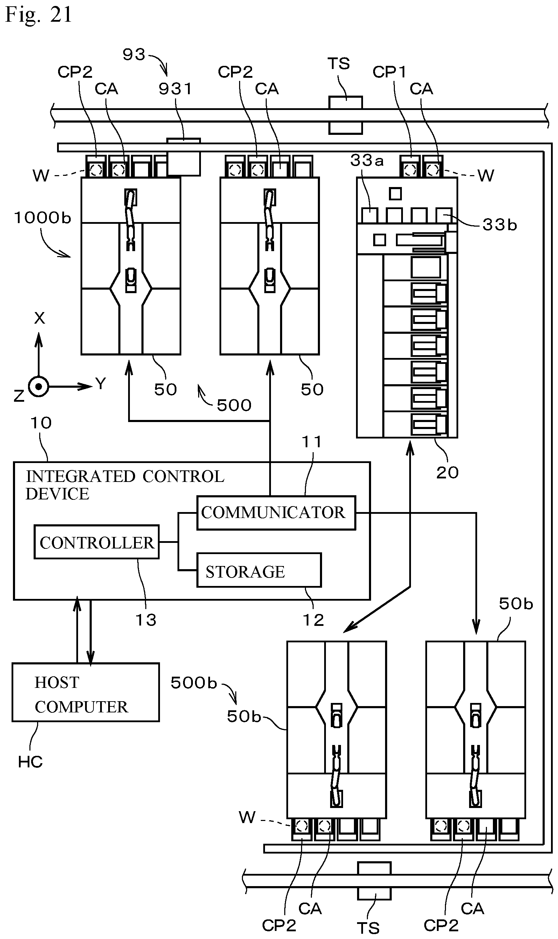

Fig. 21 is a block diagram showing a configuration of a substrate processing system 1000b according to Embodiment 4. As shown in Fig. 21, the substrate processing system 1000b further includes a plurality of second processing apparatuses 50b in addition to the constituent elements of the substrate processing system 1000a shown in Fig. 20. The other configuration of the substrate processing system 1000b is approximately the same as that of the substrate processing system 1000a shown in Fig. 20.

The second processing apparatuses 50b are sheet-fed processing apparatuses that are different in type from the aforementioned second processing apparatus 50. The second processing apparatuses 50b are different from the second processing apparatuses 50 in, for example, apparatus configuration, the type of processing fluids to be used, and the type of executable processing. For example, the second processing apparatus 50b dries substrates W by using a drying method that is different in type from the drying method used in the second processing apparatuses 50. In the following description, the second processing apparatuses 50 are also referred to as the "first-type second processing apparatus group 500," and the second processing apparatuses 50b are also referred to as the "second-type second processing apparatus group 500b." The second processing apparatuses 50 and the second processing apparatuses 50b are also collectively referred to simply as the "second processing apparatuses."

The second processing apparatuses 50b included in the second-type second processing apparatus group 500b are processing apparatuses of the same type that have approximately the same structure and that are each configured to be capable of executing the second processing on substrates W in accordance with one job. In the present embodiment, the second-type second processing apparatus group 500b includes two second processing apparatuses 50b. The number of second processing apparatuses 50b included in the second-type second processing apparatus group 500b may be three or more.

The second-type second processing apparatus group 500b is arranged in a region that is spaced from a region where the first-type second processing apparatus group 500 is located. In the example shown in Fig. 21, the second-type second processing apparatus group 500b is located on the side opposite to the first-type second processing apparatus group 500 in the direction along the transport path, with the first processing apparatus 20 sandwiched in between, the transport path being a path along which the local transport mechanism 93 transports substrate storage containers CA. The local transport mechanism 93 is capable of transporting substrate storage containers CA between the first processing apparatus 20 and the second processing apparatus groups 500b. The local transport mechanism 93 is also arranged above the second container placement parts CP2 of each second processing apparatus 50b (i.e., on the +Z side). The movable part 931 of the local transport mechanism 93 is movable also independently of the second processing apparatuses 50b.

In the substrate processing system 1000b, the integrated control device 10 controls the first processing apparatus 20, the second processing apparatuses 50, and the second processing apparatuses 50b in accordance with a command received from the host computer HC. Specifically, the integrated control device 10 generates a first virtual job and a second virtual job in accordance with a command to create an integrated job, received from the host computer HC.

The integrated control device 10 transmits the first virtual job from the communicator 11 to the first processing apparatus 20 and causes the first processing apparatus 20 to execute the first virtual job. In the present embodiment, the first virtual job causes the first processing apparatus 20 (i.e., batch processing apparatus 20) to execute the chemical solution processing and the rinse processing. While the first processing apparatus 20 is executing the chemical solution processing and the rinse processing on substrates W, the two empty substrate storage containers CA that had contained the substrates Ware placed on the first container shelf 33a and/or the second container shelves 33b.

The substrates W (i.e., the aforementioned first and second lots) that have undergone the processing executed by the first processing apparatus 20 are contained in the two substrate storage containers CA placed on the first container shelf 33a and/or the second container shelves 33b and placed on the first container placement part CP 1. The substrate storage containers CA containing the substrates W processed by the first processing apparatus 20 may be the substrate storage containers CA that had contained the substrates W before the execution of the processing by the first processing apparatus 20, or may be other substrate storage containers CA different from the substrate storage containers CAthat had contained the substrates W.

When the substrate storage containers CA containing the substrates W are placed on the first container placement parts CP 1, the integrated control device 10 selects one of the first-type second processing apparatus group 500 and the second-type second processing apparatus group 500b. For example, the one second processing apparatus group may be selected based on factors such as the contents of the dry processing indicated by the second virtual job or the size of a pattern on the substrates W, which is stored in advance in the storage 12.

When the aforementioned selection of the one second processing apparatus group (in the present embodiment, either the first-type second processing apparatus group 500 or the second-type second processing apparatus group 500b) has ended, the controller 13 of the integrated control device 10 controls the local transport mechanism 93. The movable part 931 of the local transport mechanism 93 holds the substrate storage containers CA placed on the first container placement parts CP1 and starts to move toward the region where the selected one second processing apparatus group is located.

In parallel with the aforementioned movement of the movable part 931, the integrated control device 10 selects one second processing apparatus 50 (i.e., the second processing apparatus 50 or the second processing apparatus 50b) from among the second processing apparatuses included in the selected one second processing apparatus group. The one second processing apparatus may be selected in approximately the same manner as in the case of selecting one second processing apparatus 50 in the substrate processing system 1000a. Then, the substrate storage containers CA are transported to second container placement parts CP2 of the selected one second processing apparatus by the local transport mechanism 93 and placed on the second container placement parts CP2. In this way, the substrates W processed by the first processing apparatus 20 are transported into the one second processing apparatus. The local transport mechanism 93 transports the substrate storage containers CA transported out from the first processing apparatus 20 directly into the aforementioned one second processing apparatus (i.e., the second processing apparatus 50 or the second processing apparatus 50b) without passing through the aforementioned container warehouse or the like.

When the substrate storage containers CA are placed on the second container placement parts CP2 of the aforementioned one second processing apparatus, the integrated control device 10 transmits the second virtual job from the communicator 11 to the one second processing apparatus and causes the one second processing apparatus to execute the second virtual job. In the present embodiment, the second virtual job causes the one second processing apparatus (i.e., sheet-fed processing apparatus) to execute the dry processing.

As described above, the substrate processing system 1000b includes the first processing apparatus 20, the second processing apparatuses (i.e., the second processing apparatuses 50 and the second processing apparatuses 50b), the integrated control device 10, and the local transport mechanism 93. The first processing apparatus 20 executes the first processing on substrates W in accordance with a job. The second processing apparatuses each execute the second processing on substrates W in accordance with a job. The second processing apparatuses include the first-type second processing apparatus group 500 and the second-type second processing apparatus group 500b, the second type being different from the first type. The second-type second processing apparatus group 500b is arranged in a region that is spaced from a region where the first-type second processing apparatus group 500 is located. The integrated control device 10 controls the first processing apparatus 20 and the second processing apparatuses in accordance with a command received from an external control device (i.e., the host computer HC). The local transport mechanism 93 is movable independently of the first processing apparatus 20 and the second processing apparatuses.

The job is a command to execute processing from transporting substrates W from the substrate storage containers CAinto a processing apparatus and processing the substrates W inside the processing apparatus to transporting out the substrates W from the inside of the processing apparatus to the above substrate storage containers CA or to other substrate storage containers CA different from the above substrate storage containers CA. The integrated control device 10 generates a first virtual job and a second virtual job in accordance with a command to create an integrated job, received from the host computer HC. The first processing apparatus 20 executes at least part of the first processing (in the above-described example, the chemical solution processing and the rinse processing) on substrates W in accordance with the first virtual job.

The integrated control device 10 selects one second processing apparatus group from the first-type second processing apparatus group 500 and the second-type second processing apparatus group 500b in accordance with the aforementioned command to create an integrated job and selects one second processing apparatus (i.e., the second processing apparatus 50 or the second processing apparatus 50b) from among the one second processing apparatus group. The one second processing apparatus selected from among the second processing apparatuses by the integrated control device 10 executes, in accordance with the second virtual job, at least part of the second processing (in the above-described example, the dry processing) on substrates W processed by the first processing apparatus 20.

The first processing apparatus 20 includes the first container placement parts CP1 on which substrate storage containers CA are placed. Each of the second processing apparatuses includes the second container placement parts CP2 on which substrate storage containers CA are placed. The local transport mechanism 93 transports substrate storage containers CA containing substrates W processed by the first processing apparatus 20 from the first container placement parts CP1 to second container placement parts CP2 of the aforementioned one second processing apparatus (i.e., the second processing apparatus 50 or the second processing apparatus 50b) selected from among the second processing apparatuses.

Accordingly, the substrate storage containers CA can be easily transported to the one second processing apparatus that is selected appropriately from among the second processing apparatuses (i.e., the first-type second processing apparatus group 500 and the second-type second processing apparatus group 500b). As approximately in the case of the substrate processing system 1000a, it is also possible to shorten the time from the end of the processing executed on the substrates W by the first processing apparatus 20 to the start of the processing executed on the substrates W by the one second processing apparatus.

As described above, in the substrate processing system 1000b, the substrate storage containers CA containing the substrates W processed by the first processing apparatus 20 are transported from the first processing apparatus 20 to one second processing apparatus group (i.e., the first-type second processing apparatus group 500 or the second-type second processing apparatus group 500b) selected by the integrated control device 10. Then, preferably in parallel with this transport, one second processing apparatus (i.e., second processing apparatus 50 or the second processing apparatus 50b) is selected as the second processing apparatus that executes the second virtual job from the one second processing apparatus group by the integrated control device 10. This further shortens the time from the end of the processing executed on the substrates W by the first processing apparatus 20 to the start of the processing executed on the substrates W by the one second processing apparatus.

As described above, it is preferable that the first processing apparatus 20 includes a batch-type substrate processing apparatus capable of processing a plurality of substrates W by one operation, and each of the second processing apparatuses includes a sheet-fed-type substrate processing apparatus that processes the substrates one by one. This enables favorably achieving hybrid processing in which sheet-fed processing is executed on substrates W after batch processing is executed on the substrates W.

Embodiments of the present invention have been described thus far with reference to the drawings (Figs. 1 to 21). It is, however, noted that the present invention is not intended to be limited to the embodiments described above, and may be implemented in various modes without departing from the scope of the present invention. A plurality of constituent elements disclosed in the above-described embodiments may be modified as appropriate. For example, some of all constituent elements described in a given embodiment may be added to constituent elements according to a different embodiment, or some of all constituent elements described in a given embodiment may be deleted from the embodiment.

The drawings primarily show each constituent element schematically in order to facilitate understanding of the present invention and, for convenience in creating the drawings, features shown in the drawings, such as thickness, length, number, and intervals of each constituent element, may differ from the actual features. The configuration of each constituent element exemplified in the above-described embodiments is merely one example and not particularly limited. It goes without saying that various modifications are possible without substantially departing from the advantageous effects of the present invention.

For example, while the embodiments described with reference to Figs. 1 to 21 show the configurations for processing substrates W by using the first processing apparatus 20 and the second processing apparatuses 50 and 50b, the integrated control device 10 may cause only the first processing apparatus 20 to process the substrates W, or may cause only the second processing apparatus 50 or 50b to process the substrates W. In this case, either one of the first recipe RP1 and the second recipe RP2 is integrated into the integrated job.

While the embodiments described with reference to Figs. 1 to 21 show combinations of a batch-type cleaning device or etching device and a sheet-fed cleaning device or etching device, the combinations of the first processing apparatus 20 and the second processing apparatuses 50 and 50b are not limited thereto. For example, the combinations of the first processing apparatus 20 and the second processing apparatuses 50 or 50b may be a combination of a scrubber cleaning device and a batch cleaning device, a combination of a film thickness inspection apparatus and a cleaning device, a combination between a warpage measuring device and a lamp annealing device, or a combination of a cleaning device and a particle count device.

While the embodiments described with reference to Figs. 1 to 21 use part of the first processing that can be executed by the first processing apparatus 20, all the processing that can be executed by the first processing apparatus 20 may be used. The same applies to the second processing apparatuses 50 and 50b. For example, in the case where the first processing apparatus 20 is a membrane thickness inspection device, all the processing that can be executed by the first processing apparatus 20 may be used.

While the embodiments described with reference to Figs. 1 to 21 use combinations of a batch processing apparatus and a sheet-fed processing apparatus, batch processing apparatuses may be used in combination, or sheet-fed processing apparatuses may be used in combination.

While the embodiments described with reference to Figs. 1 to 21 combine batch processing and sheet-fed processing, batch processing may be combined with another batch processing, or sheet-fed processing may be combined with another sheet-fed processing. As another alternative, for example, a plurality of processing apparatuses capable of executing the same processing may be combined together.

While the substrate processing system 1000 according to the embodiment described with reference to Figs. 1 to 19 includes the first coupler 80 and the second coupler 90, the substrate processing system 1000 may include only one of the first coupler 80 and the second coupler 90.

While the embodiments described with reference to Figs. 1 to 19 use a combination of two processing apparatuses, three or more processing apparatuses may be combined together as in the embodiments described with reference to Figs. 20 and 21.

In the embodiments described with reference to Figs. 1 to 19, virtual placement information (information indicating that a virtual substrate storage container is placed on a virtual load port) is generated in response to the second orientation conversion mechanism converting the orientation of one lot from a vertical position to a horizontal position and then adjusting the position of the one lot in the up-down direction such that that the uppermost substrate W of the one lot is located above the liquid level of the immersion tank. Alternatively, the virtual placement information may be generated in response to the second orientation conversion mechanism converting the orientation of one lot from a vertical position to a horizontal position.

In the embodiments described with reference to Figs. 1 to 19, the first coupler 80 includes the substrate standby part 40, but the substrate standby part 40 may be included in the first processing apparatus 20.

While the embodiment described with reference to Fig. 21 shows the two second processing apparatus groups, but three or more second processing apparatus groups may be provided.

While the invention has been shown and described in detail, the foregoing description is in all aspects illustrative and not restrictive. It is therefore understood that numerous modifications and variations can be devised without departing from the scope of the invention.

The present invention is usable for a device, system, and method for processing substrates.

### REFERENCE SIGNS LIST

- 10: integrate controller
- 20: first processing apparatus; batch processing apparatus
- 21: first control device
- 23: first storage
- 31: first casing
- 31a: first opening
- 40: substrate standby part
- 50, 50b: second processing apparatus; sheet-fed processing apparatus
- 51: second control device
- 53: second storage
- 61: second casing
- 61a: second opening
- 80: first coupler
- 81: first coupler casing
- 82: substrate transport mechanism
- 90: second coupler
- 91: second coupler casing
- 92: second container transport mechanism
- 93: local transport mechanism
- 1000, 1000a, 1000b: substrate processing system
- A to D: recipe
- CA: substrate storage container
- CA1: first substrate storage container
- CA2: second substrate storage container
- CP1: first container placement part
- CP2: second container placement part
- G1: first recipe editing screen
- G2: second recipe editing screen
- HC: host computer
- HR: integrated recipe information
- LP1: first load port
- LP2: second load port
- LP3: third load port
- RP1: first recipe
- RP2: second recipe
- W: substrate

## Claims

1. A substrate processing system (1000) comprising:
a first processing apparatus (20) that executes first processing on a substrate (W) in accordance with a job;
a second processing apparatus (50) that executes second processing on a substrate (W) in accordance with a job; and
an integrated control device (10) that controls said first processing apparatus (20) and said second processing apparatus (50) in accordance with a command received from an external control device (HC),
wherein said job is a command to execute processing from transporting a substrate (W) from a substrate storage container (CA) into a processing apparatus and executing processing on the substrate (W) inside said processing apparatus to transporting out the substrate (W) from the inside of the processing apparatus to said substrate storage container (CA) or to another substrate storage container (CA) different from said substrate storage container (CA), and
said integrated control device (10) is configured to:
generate a first virtual job and a second virtual job in accordance with a command to create an integrated job, the command being received from said external control device (HC);
cause said first processing apparatus (20) to execute at least part of said first processing on a substrate (W) in accordance with said first virtual job; and
cause said second processing apparatus (50) to execute at least part of said second processing on said substrate (W) processed by said first processing apparatus (20), in accordance with said second virtual job.

2. The substrate processing system (1000) according to claim 1, further comprising:
a first coupler (80) that couples said first processing apparatus (20) and said second processing apparatus (50),
wherein said first coupler (80) includes a substrate transport mechanism (82) that transports said substrate (W) processed by said first processing apparatus (20) to said second processing apparatus (50).

3. The substrate processing system (1000) according to claim 2, further comprising:
a substrate standby part (40) in which said substrate (W) having undergone at least part of said first processing is on standby,
wherein said substrate transport mechanism (82) transports said substrate (W) that is on standby in said substrate standby part (40) to said second processing apparatus (50), and
said integrated control device (10) generates said second virtual job in response to said substrate (W) becoming on standby in said substrate standby part (40).

4. The substrate processing system (1000) according to claim 3, wherein
said second processing apparatus (50) includes a storage that stores information for identifying a virtual container placement part, and
said integrated control device (10) generates, in response to said substrate (W) becoming on standby in said substrate standby part (40), information indicating that a virtual substrate storage container is placed on said virtual container placement part.

5. The substrate processing system (1000) according to any one of claims 2 to 4, wherein
said first processing apparatus (20) includes a first casing (31) having a first opening (3 1a),
said second processing apparatus (50) includes a second casing (61) having a second opening (61a),
said first coupler (80) further includes a first coupler casing (81),
said first coupler casing (81) has one end connected to said first casing (31),
said first coupler casing (81) has the other end connected to said second casing (61), and
said substrate transport mechanism (82) transports out said substrate (W) processed by said first processing apparatus (20) through said first opening (31a) of said first casing (31), transports said substrate (W) through an interior of said first coupler casing (81), and transports said substrate (W) from said second opening (61a) into said second casing (61).

6. The substrate processing system (1000) according to any one of claims 1 to 4, further comprising:
a second coupler (90) that couples said first processing apparatus (20) and said second processing apparatus (50),
wherein said first processing apparatus (20) includes a first casing (31) and a first container placement part (CP1) on which a substrate storage container (CA) is placed,
said second processing apparatus (50) includes a second casing (61) and a second container placement part (CP2) on which said substrate storage container (CA) is placed,
said first container placement part (CP1) is provided outside said first casing (31),
said second container placement part (CP2) is provided outside said second casing (61), and
said second coupler (90) includes a container transport mechanism (92) that transports said substrate storage container (CA) placed on said first container placement part (CP1) to said second container placement part (CP2).

7. The substrate processing system (1000) according to claim 6, wherein
said second coupler (90) further includes a second coupler casing (91) that covers said first container placement part (CP1) and said second container placement part (CP2), and
said container transport mechanism (92) transports said substrate storage container (CA) inside said second coupler casing (91).

8. The substrate processing system (1000) according to any one of claims 1 to 4, wherein
said first processing apparatus (20) includes a first storage (23) that stores a first recipe (RP 1) that prescribes said first processing,
said second processing apparatus (50) includes a second storage (53) that stores a second recipe (RP2) that prescribes said second processing,
said integrated control device (10) edits an integrated recipe that integrates said first recipe (RP1) and said second recipe (RP2) with each other, and stores integrated recipe information (HR),
when a command to create said integrated job is received from said external control device (HC), said integrated control device (10) generates said first virtual job and said second virtual job with reference to said integrated recipe information (HR),
said first virtual job includes information for identifying said first recipe (RP1) integrated into said integrated recipe, and
said second virtual job includes information for identifying said second recipe (RP2) integrated into said integrated recipe.

9. The substrate processing system (1000) according to claim 8, wherein
said first processing apparatus (20) executes part of said first processing, and
when editing said integrated recipe, said integrated control device (10) edits said first recipe (RP1) so that part of said first processing is executed in accordance with the command received from said external control device (HC).

10. The substrate processing system (1000) according to claim 8, wherein
said second processing apparatus (50) executes part of said second processing, and
when editing said integrated recipe, said integrated control device (10) edits said second recipe (RP2) so that part of said second processing is executed in accordance with the command received from said external control device (HC).

11. The substrate processing system (1000) according to claim 8, wherein
said first storage (23) stores a plurality of first recipes (RP1) that are different from each other and each are said first recipe (RP1),
when editing said integrated recipe, said integrated control device (10) integrates said first recipe (RP1) into said integrated recipe in a unit of one substrate (W), and
when two or more of said plurality of first recipes (RP1) are integrated into said integrated recipe, said integrated control device (10) generates two or more first virtual jobs each being said first virtual job.

12. The substrate processing system (1000) according to claim 8, wherein
said second storage (53) stores a plurality of second recopies (RP2) that are different from each other and each are said second recipe (RP2),
when editing said integrated recipe, said integrated control device (10) integrates said second recipe (RP2) into said integrated recipe in a unit of one substrate (W), and
when two or more of said plurality of second recipes (RP2) are integrated into said integrated recipe, said integrated control device (10) generates two or more second virtual jobs each being said second virtual job.

13. The substrate processing system (1000) according to any one of claims 1 to 4, wherein
said first processing apparatus (20) notifies said integrated control device (10) of an event that has occurred in said first processing apparatus (20), together with information for identifying said first virtual job,
said second processing apparatus (50) notifies said integrated control device (10) of an event that has occurred in said second processing apparatus (50), together with information for identifying said second virtual job, and
said integrated control device (10) is configured to:
notify said external control device (HC) of the event that has occurred in said first processing apparatus (20), together with information for identifying said integrated job; and
notify said external control device (HC) of the event that has occurred in said second processing apparatus (50), together with information for identifying said integrated job.

14. The substrate processing system (1000) according to claim 13, wherein
the event that has occurred in said first processing apparatus (20) includes a completed event that indicates completion of processing based on said first virtual job, and
when an event notified from said first processing apparatus (20) is a completed event indicating completion of said first virtual job, said integrated control device (10) determines not to notify said external control device (HC) of the completed event.

15. The substrate processing system (1000) according to claim 13, wherein
said integrated control device (10) generates said second virtual job a plurality of times,
the event that has occurred in said second processing apparatus (50) includes a plurality of completed events that respectively indicate completion of processing based on a plurality of second virtual jobs each being said second virtual job,
said plurality of completed events include a last completed event that is a completed event notified at last from said second processing apparatus (50), and
said integrated control device (10) is configured to:
when the completed event notified from said second processing apparatus (50) is not said last completed event, determine not to notify said external control device (HC) of the completed event; and
when the completed event notified from said second processing apparatus (50) is said last completed event, notify said external control device (HC) of the completed event, together with information for identifying said integrated job.

16. The substrate processing system (1000) according to any one of claims 1 to 4, wherein
said first processing apparatus (20) includes a first control device (21) that controls execution of said first processing,
said second processing apparatus (50) includes a second control device (51) that controls execution of said second processing, and
one of said first control device (21) and said second control device (51) serves also as said integrated control device (10).

17. The substrate processing system (1000) according to any one of claims 1 to 4, wherein
said first processing apparatus (20) includes a batch-type substrate processing apparatus capable of processing a plurality of substrates (W) by one operation, and
said second processing apparatus (50) includes a sheet fed-type substrate processing apparatus that processes a plurality of substrates (W) one by one.

18. The substrate processing system (1000) according to claim 17, wherein
said integrated control device (10) generates said first virtual job to control said batch-type substrate processing apparatus,
said batch-type substrate processing apparatus executes part of said first processing on said plurality of substrates (W) in accordance with said first virtual job,
after said batch-type substrate processing apparatus has completed the processing on said plurality of substrates (W), said integrated control device (10) generates said second virtual job to control said sheet fed-type substrate processing apparatus,
said sheet fed-type substrate processing apparatus executes part of said second processing on each of some of said plurality of substrates (W) in a unit of one substrate (W) in accordance with said second virtual job,
after said sheet fed-type substrate processing apparatus has completed the processing on the some of said plurality of substrates (W), said integrated control device (10) again generates said second virtual job to control said sheet fed-type substrate processing apparatus, and
said sheet fed-type substrate processing apparatus executes part of said second processing on each of remaining ones of said plurality of substrates (W) in a unit of one substrate (W) in accordance with said second virtual job.

19. A substrate processing system (1000a, 1000b) comprising:
a first processing apparatus (20) that executes first processing on a substrate (W) in accordance with a job;
a plurality of second processing apparatuses (50) that each execute second processing on a substrate (W) in accordance with a job;
an integrated control device (10) that controls said first processing apparatus (20) and said plurality of second processing apparatuses (50) in accordance with a command received from an external control device (HC); and
a local transport mechanism (93) that is movable independently of said first processing apparatus (20) and said plurality of second processing apparatuses (50),
wherein said job is a command to execute processing from transporting a substrate (W) from a substrate storage container (CA) into a processing apparatus and executing processing on the substrate (W) inside the processing apparatus to transporting out the substrate (W) from an interior of the processing device to said substrate storage container (CA) or to another substrate storage container (CA) different from said substrate storage container (CA),
said integrated control device (10) generates a first virtual job and a second virtual job in accordance with a command to create an integrated job, the command being received from said external control device (HC),
said first processing apparatus (20) executes at least part of said first processing on a substrate (W) in accordance with said first virtual job,
one second processing apparatus (50) selected from among said plurality of second processing apparatuses (50) by said integrated control device (10) executes, in accordance with said second virtual job, at least part of said second processing on said substrate (W) processed by said first processing apparatus (20),
said first processing apparatus (20) includes a first container placement part (CP1) on which a substrate storage container (CA) is placed,
each of said plurality of second processing apparatuses (50) includes a second container placement part (CP2) on which said substrate storage container (CA) is placed, and
said local transport mechanism (93) transports said substrate storage container (CA) that contains said substrate (W) processed by said first processing apparatus (20), from said first container placement part (CP1) to said second container placement part (CP2) of said one second processing apparatus (50) selected from among said plurality of processing apparatuses (50).

20. The substrate processing system (1000a, 1000b) according to claim 19, wherein
said integrated control device (10) stores processing standby information and maintenance information and selects said one second processing apparatus (50) from among said plurality of second processing apparatuses (50) in accordance with the processing standby information and the maintenance information that are about each of said plurality of second processing apparatuses (50), the processing standby information indicating a total number of substrates (W) that are on standby in each of said plurality of second processing apparatuses (50), the maintenance information being information about each of said plurality of second processing apparatuses (50).

21. The substrate processing system (1000b) according to claim 19, wherein
said plurality of second processing apparatuses (50, 50b) include:
a second processing apparatus group (500) of a first type; and
a second processing apparatus group (500b) of a second type different from said first type,
the second processing apparatus group (500b) of said second type is arranged in a region that is spaced from a region in which the second processing apparatus group (500) of said first type is arranged, and
said integrated control device (10) selects one second processing apparatus group out of the second processing apparatus group (500) of said first type and the second processing apparatus group (500b) of said second type in accordance with a command to create said integrated job, and selects said one second processing apparatus (50, 50b) from among said one second processing apparatus group.

22. The substrate processing system (1000a, 1000b) according to any one of claims 19 to 21, wherein
said first processing apparatus (20) includes a batch-type substrate processing apparatus capable of processing a plurality of substrates (W) by one operation, and
each of said plurality of second processing apparatuses (50) includes a sheet fed-type substrate processing apparatus that processes a plurality of substrates (W) one by one.
